# EUROPEAN PATENT SPECIFICATION

(11) **EP 1 757 984 B1**
(45) Date of publication and mention of the grant of the patent: **18.05.2016**
(21) Application number: 06017401.8
(22) Date of filing: 22.08.2006
(51) Int. Cl.: G03F 7/09, G03F 7/11, B41C 1/10

(54) **Photosensitive lithographic printing plate**
Lichtempfindliche Lithografiedruckform
Plaque d'impression lithographique photosensible

(30) Priority: 22.08.2005 JP 2005240088
(43) Date of publication of application: 28.02.2007
(73) Proprietor: FUJIFILM Corporation, Minato-ku Tokyo (JP)
(72) Inventor: Mori, Takanori, Yoshida-cho Haibara-gun Shizuoka (JP)
(74) Representative: Hoffmann Eitle

(56) References cited:
- EP-A- 1 450 207
- EP-A- 1 562 078
- EP-A2- 1 152 294
- WO-A-2005/029190
- US-A- 5 922 508
- US-A1- 2002 068 240
- US-A1- 2002 098 447

## Description

### FIELD OF THE INVENTION

The present invention relates to a negative-working photosensitive lithographic printing plate capable of conducting direct plate-making by scanning of laser based on digital signal from a computer or the like.

### BACKGROUND OF THE INVENTION

In negative-working photosensitive lithographic printing plates, in general, image formation is carried out by a process of coating a photosensitive composition on a support, for example, an aluminum plate subjected to surface roughening treatment to form a photosensitive layer, exposing a desired image to polymerize or crosslink the exposed area of the photosensitive layer to insolubilize it in a developer, and dissolving out the unexposed area of the photosensitive layer with the developer. As photosensitive compositions used for such a purpose, photopolymerizable compositions have hitherto been well known, a part of which is already put into practical use. Also, as for recent photopolymerizable compositions which adopt a photo-initiation system technology that is highly sensitive to visible light, the sensitivity increases to a region employable for direct plate making by a visible laser, and a so-called CTP plate becomes widespread.

As the representative examples of the negative-working photosensitive lithographic printing plate responding to an ultraviolet or visible laser, photosensitive lithographic printing plates having a photosensitive layer using a radical polymerization system composition are known (see, for example,

JP-A-8-220758 (the term "JP-A" as used herein means an "unexamined published Japanese patent application") and JP-A-2000-35673).

Since sensitivity of the radical polymerization system is remarkably decreased due to polymerization inhibition caused by oxygen in the air, an oxygen-blocking protective layer is ordinarily provided in the photosensitive lithographic printing plate using the radical polymerization system in order to prevent the decrease in sensitivity. However, when the oxygen-blocking function of the protective layer is high, the sensitivity increases so that even the unexposed area is hardened by a slight amount of radical generated by scattering light at the exposure to cause a so-called flare problem in that stain occurs at printing. In order to remove the defect, it is proposed that the flare problem is solved by using a protective layer of low oxygen-blocking property and the decrease in sensitivity caused by the low oxygen-blocking property is compensated by increasing a content of polymerizable compound used in the photosensitive layer (see JP-A-2003-98674). Further, when the oxygen-blocking function of the protective layer is high, the formation of fog may occur due to dark polymerization, resulting in degradation of preservation stability. In order to prevent the problem, it is ordinarily conducted to add a polymerization inhibitor to the photosensitive layer.

However, the flare problem is not completely solved in the prior art and thus, particularly in highly accurate image areas, sometimes tone reproducibility becomes unstable under the influence of fluctuation in brush pressure based on, for example, fatigue of the brush in an automatic developing machine.

US-A-2002/0098447, WO 2005/029190 and US-A-5922508 each discloses a photosensitive lithographic printing plate comprising a hydrophilic support, a photosensitive layer and a protective layer in this order. Their respective photosensitive layers contain a compound having an ethylenically unsaturated double bond and a polymer binder. Their respective protective layers contain an alkyl sulfonated salt. The similar US-A-2002/0068240 is in respect of a thermosensitive lithographic printing plate.

### SUMMARY OF THE INVENTION

An object of the present invention is to provide a photosensitive lithographic printing plate which is excellent in the tone reproducibility without decrease in the sensitivity.

Since the scattering light at the exposure has low energy, it hardens only the upper portion of the photosensitive layer and the hardening hardly proceeds in the lower portion of the photosensitive layer so that difference in developing property arises in the direction of thickness of the photosensitive layer. Thus, it is believed that in the highly accurate image areas, reproducibility of halftone dot is degraded due to processing unevenness or the like and that control of the developing property in the direction of thickness of the photosensitive layer is very important in order to solve the flare problem.

Therefore, it is also believed that when it is possible to control an interfacial state between the photosensitive layer and the protective layer and to increase permeability of developer in the upper portion of the photosensitive layer, the difference in developing property between the upper portion and the lower portion of the photosensitive layer is restrained and as a result, the tone reproducibility is improved.

As a result of intensive investigations, the inventor has found that the above-described object can be achieved by incorporating a compound having a sulfonate or a sulfate ester salt in a specific amount into the protective layer to complete the invention. Specifically, the present invention includes the following items.
(1) A photosensitive lithographic printing plate comprising a hydrophilic support having thereon a photosensitive layer and a protective layer in this order, wherein the photosensitive layer contains a compound having an ethylenically unsaturated double bond and a polymer binder and protective layer contains a sulfonate or a sulfate ester salt in an amount from 0.5 to 10% by weight calculated in terms of a solid content of the protective layer represented by the formula R-SO₃M or R-OSO₃M wherein R represents an optionally substituted aryl group and M represents a monovalent cation for forming a salt.
(2) The photosensitive lithographic printing plate as described in (1), wherein the compound having a sulfonate or a sulfate ester salt in the protective layer is a surfactant.
(3) The photosensitive lithographic printing plate as described in (1) or (2), wherein a content of the compound having a sulfonate or a sulfate ester salt is from 0.7 to 8% by weight calculated in terms of the solid content of the protective layer.
(4) The photosensitive lithographic printing plate as described in any one of (1) to (3), wherein a content of the compound having a sulfonate or a sulfate ester salt is from 1 to 5% by weight calculated in terms of the solid content of the protective layer.
(5) The photosensitive lithographic printing plate as described in any one of (1) to (4), wherein the polymer binder in the photosensitive layer is a (meth)acrylic resin.
(6) The photosensitive lithographic printing plate as described in any one of (1) to (5), wherein the protective layer contains 85% by weight or more of polyvinyl alcohol calculated in terms of the solid content of the protective layer.

According to the present invention, a photosensitive lithographic printing plate which is excellent in the tone reproducibility without decrease in the sensitivity can be provided.

### DETAILED DESCRIPTION OF THE INVENTION

The present invention will be described in detail below.

### <Protective layer>

The protective layer according to the invention is characterized by containing a compound having a sulfonate or a sulfate ester salt. When the compound having a sulfonate or a sulfate ester salt is incorporated into a protective layer comprising polyvinyl alcohol or the like, the preservation stability is remarkably increased.

Of the compounds having a sulfonate or a sulfate ester salt, preferred are those in which R represents a phenyl group which may have a substituent or a naphthyl group which may have a substituent in view of the control of interface between the photosensitive layer and the protective layer.

In the formulae, M represents a monovalent cation for forming a salt with R-SO₃ or R-OSO₃, and is preferably an alkali metal, more preferably sodium, from the standpoint that the compound is soluble or readily-soluble in water.

A weight average molecular weight of the compound having a sulfonate or a sulfate ester salt is from 150 to 1,000, preferably from 200 to 500. When the weight average molecular weight of the compound is too low, the hydrophilicity becomes too high and the effect for controlling interface between the photosensitive layer and the protective layer decreases. On the contrary, when it is too high, the solubility in water decreases.

An amount of the compound having a sulfonate or a sulfate ester salt added is ordinarily from 0.5 to 10% by weight, preferably from 0.7 to 8% by weight, and particularly preferably from 1 to 5% by weight, based on the total solid content of the protective layer. When the amount of the compound added is too small, the effect for controlling interface between the photosensitive layer and the protective layer decreases. On the contrary, when it is too large, coating property of the protective layer may be degraded to cause unevenness of coating.

It is preferable that the compound having a sulfonate or a sulfate ester salt is a surfactant.

Specific examples of the compound having a sulfonate or a sulfate ester salt include an anionic surfactant, for instance, an alkylbenzenesulfonate, for example, sodium dodecylbenzenesulfonate or an alkylnaphthalenesulfonate, for example, sodium butylnaphthalenesulfonate, sodium pentylnaphthalenesulfonate, sodium hexylnaphthalenesulfonate or sodium octylnaphthalenesulfonate.

As for the characteristics required of the protective layer, it is desired that the protective layer controls the oxygen-blocking property, does not substantially hinder the transmission of light used for the exposure, is excellent in adhesion to the photosensitive layer, and can be easily removed during a development step after the exposure.

The protective layer contains a binder. As the binder for use in the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid, polyacrylamide, polyester or polyurethane is enumerated. The water-soluble polymer compounds may be used individually or as a mixture. Of the compounds, when polyvinyl alcohol is used as a main component, the best results can be obtained in view of fundamental characteristics, for example, the oxygen-blocking property and removability upon development.

The polyvinyl alcohol for use in the protective layer may be partially substituted with ester, ether or acetal as long as it contains unsubstituted vinyl alcohol units necessary for achieving the required oxygen-blocking property and water solubility. Also, a part of the polyvinyl alcohol may have other copolymer component. As specific examples of the polyvinyl alcohol, those having a saponification degree raging from 71 to 100% by mole and a polymerization degree ranging from 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, KL-506, KL-318, KL-118, KM-618, KM-118, C-506, R-2105, R-1130, R-2130, M-205, MP-203, LM15, LM20 and LM25 (each produced by Kuraray Co., Ltd.). They can be used individually or as a mixture. According to a preferred embodiment, a content of polyvinyl alcohol in the protective layer is 85% by weight or more, calculated in terms of the solid content.

Also, it is possible to add filler, for example, silica gel or mica to the protective layer in order to control the surface properties. Further, the protective layer may contain an inorganic stratiform compound. The inorganic stratiform compound is a particle having a thin tabular shape and includes, for example, mica, for example, natural mica represented by formula: A (B, C)₂₋₅ D₄ O₁₀ (OH, F, O)₂, (wherein A represents any one of K, Na and Ca, B and C each represents any one of Fe (II), Fe(III), Mn, Al, Mg and V, and D represents Si or Al) or synthetic mica; talc represented by formula: 3MgO·4SiO·H₂O; teniolite; montmorillonit; saponite; hectolite; and zirconium phosphate.

Of the micas, examples of the natural mica include muscovite, paragonite, phlogopite, biotite and lepidolite. Examples of the synthetic mica include non-swellable mica, for example, fluorine phlogopite KMg₃(AlSi₃O₁₀)F₂ or potassium tetrasilic mica KMg_{2.5}(Si₄O₁₀)F₂, and swellable mica, for example, Na tetrasililic mica NaMg_{2.5}(Si₄O₁₀)F₂, Na or Li teniolite (Na, Li)Mg₂Li(Si₄O₁₀)F₂, or montmorillonit based Na or Li hectolite (Na, Li)_{1/8}Mg_{2/5}Li_{1/8}(Si₄O₁₀)F₂. Synthetic smectite is also useful.

As for the particle size of the inorganic stratiform compound, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For instance, in case of the swellable synthetic mica that is the representative compound of the inorganic stratiform compounds, thickness is approximately from 1 to 50 nm and plain size is approximately from 1 to 20 µm.

The protective layer preferably has oxygen permeability (A) at 25°C under 1 atmosphere of 1.0 ≤ A ≤ 20 (cm³/m²·day). When the oxygen permeability is controlled in the above-described range, problems in that an undesirable polymerization reaction arises during the production or preservation before image exposure of the photosensitive lithographic printing plate and in that undesirable fog or spread of image line generates at the image exposure are prevented and preferable sensitivity is achieved.

To the protective layer according to the invention, other surfactant may be added, if desired, in addition to the compound having a sulfonate or a sulfate ester salt. As such surfactants, for example, nonionic surfactants, for example, polyoxyethylene castor oil ether, polyoxyethylene alkyl ether (e.g., polyoxyethylene lauryl ether, polyoxyethylene cetyl ether or polyoxyethylene stearyl ether), polyoxyethylene alkyl aryl ether (e.g., polyoxyethylene octyl phenyl ether or polyoxyethylene nonyl phenyl ether), polyoxyethylene alkyl ester (e.g., polyoxyethylene stearate), sorbitan alkylester (e.g., sorbitan monolaurate, sorbitan monostearate, sorbitan distearate, sorbitan monooleate, sorbitan sesquioleate or sorbitan trioleate) and monoglyceride alkyl ester (e.g., glycerol monostearate or glycerol monooleate); and amphoteric surfactants, for example, alkyl betaine (e.g., lauryl betaine or stearyl betaine) and amino acid can be used. Particularly, the nonionic surfactant is preferably used in order to improve film properties of the protective layer.

As the particularly preferable surfactant, a polyoxyethylene castor oil ether surfactant is exemplified. The castor oil that is the main component of the polyoxyethylene castor oil ether surfactant is a vegetal nondrying oil obtained from seed of castor-oil plant by a press method. The seed of castor-oil plant contains from 35 to 57% of castor oil. The component of the castor oil includes about 85% of ricinoleic acid, which is an unsaturated carboxylic acid. The ricinoleic acid is a derivative of stearic acid, which has a carboxy group at a terminal, a hydroxy group at 12 position and an unsaturated double bong at 9 position. The polyoxyethylene castor oil ether surfactant is a generic term of nonionic surfactants synthesized by addition of ethylene oxide to ricinoleic acid, which is the main component of the castor oil. Depending on conditions during the addition reaction, the hydroxy group and the carboxylic acid group of ricinoleic acid are reacted with each other between the molecules of ricinoleic acids to from a polyester, whereby a surfactant containing a polymer having a molecular weight of 10,000 to 20,000 can also be formed.

The polyoxyethylene castor oil ether surfactant also includes a surfactant formed by addition of ethylene oxide to glycerol of ricinoleic acid.

The polyoxyethylene castor oil ether surfactant used in the invention has an HLB value ordinarily from 10.0 to 16.0, preferably from 11.0 to 15.0. When the HLB value of the surfactant is smaller than 10.0, the surfactant has low water-solubility so as to form turbidity by the addition thereof to an aqueous solution of polyvinyl alcohol. On the other hand, the HLB value of the surfactant is larger than 16.0, the hydrophilicity is too high so that hygroscopic property of the protective layer undesirably increases. A weight average molecular weight of the polyoxyethylene castor oil ether surfactant is ordinarily from 800 to 5,000, preferably from 1,000 to 3,000. When the weight average molecular weight of the surfactant is too low, the effect for improving the film properties of the protective layer decreases. On the other hand when the weight average molecular weight of the surfactant is too high, the solubility decreases.

Specific examples of the polyoxyethylene castor oil ether surfactant include Pionin D-225, Pionin D-240-W, Pionin D-230, Pionin D-236 and Pionin D-225-K each produced by Takemoto Oil & Fat Co., Ltd., and Emanon CH-25, Emanon CH-40 and Emanon CH-60 each produced by Kao Corp.

An amount of the polyoxyethylene castor oil ether surfactant added is ordinarily from 1.0 to 10% by weight, preferably from 2.0 to 6.0% by weight, based on the total solid content of the protective layer. When the amount of the surfactant added is too small, the effect for improving the film properties of the protective layer decreases. On the other hand, when the amount of the surfactant added is too large, coating property of the protective layer is degraded to cause unevenness of coating.

A coating amount of the protective layer is ordinarily from 0.1 to 10 g/m², preferably from 0.5 to 5 g/m², in terms of weight after drying.

### <Photosensitive layer>

The photosensitive layer in the photosensitive lithographic printing plate of the invention contains a compound having an ethylenically unsaturated double bond (hereinafter, simply abbreviated as an "ethylenically unsaturated bond-containing compound") and a polymer binder, preferably a polymer binder soluble or swellable in alkali water having a crosslinkable group. The photosensitive layer further contains a polymerization initiation system and, if desired, various compounds, for example, a coloring agent, a plasticizer or a thermal polymerization inhibitor.

### [Ethylenically unsaturated bond-containing compound]

The ethylenically unsaturated bond-containing compound is a compound having at least one ethylenically unsaturated bond, which is addition-polymerized by the action of a photopolymerization initiator to contribute to crosslinking or hardening, when the photosensitive layer is irradiated with active radiation.

The ethylenically unsaturated bond-containing compound can be appropriately selected, for example, from compounds having at least one, preferably two or more, more preferably from two to six terminal ethylenically unsaturated bonds. The compound has a chemical form, for example, a monomer, a prepolymer (i.e., dimmer, trimer or oligomer), or a mixture thereof

Examples of the ethylenically unsaturated bond-containing compound include esters between an unsaturated carboxylic acid (for example, acrylic acid, methacrylic acid, itaconic acid, crotonic acid, isocrotonic acid or maleic acid) and an aliphatic polyhydric alcohol compound and amides between the unsaturated carboxylic acid and an aliphatic polyvalent amine compound. Specific examples of the monomer of the ester between an aliphatic polyhydric alcohol compound and an unsaturated carboxylic acid include acrylates, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer; methacrylates, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane or bis-[p-(methacryloxyethoxy)phenyl]dimethylmethane; itaconates, for example, ethylene glydcol diitaconate, propylene glycol diitaconate, 1,5-butanediol diitaconate, 1,4-butanediol diitaconate, tetramethylene glycol diitaconate, pentaerythritol diitaconate or sorbitol tetraitaconate; crotonatates, for example, ethylene glycol dicrotonate, tetramethylene glycol dicrotonate, pentaerythritol dicrotonate or sorbitol tetradicrotonate; isocrotonates, for example, ethylene glycol diisocrotonate, pentaerythritol diisocrotonate or sorbitol tetraisocrotonate;
and maleates, for example, ethylene glycol dimaleate, triethylene glycol dimaleate, pentaerythritol dimaleate or sorbitol tetramaleate.

Two or more of the ester monomers described above may be used as a mixture.

Also, specific examples of the monomer of the amide between an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Other examples of the ethylenically unsaturated bond-containing compound include vinylurethane compounds having two or more polymerizable vinyl groups per molecule described in JP-B-48-41708 (the term "JP-B" as used herein means an "examined Japanese patent publication"), which are obtained by adding a hydroxy group-containing vinyl monomer represented by formula (m) shown below to a polyisocyanate compound having two or more isocyanate groups per molecule.

CH₂=C(R)COOCH₂CH(R')OH (m)

wherein R and R' each independently represents H or CH₃.

Also, urethane acrylates described in JP-A-51-37193 and JP-B-2-32293, polyester acrylates described in JP-A-48-64183, JP-B-49-43191 and JP-B-52-30490, and polyfunctional acrylates or methacrylates, for example, epoxyacrylates obtained by reacting an epoxy resin with (meth)acrylic acid are set forth. Further, photo-curable monomers and oligomers described in Nippon Secchaku Kyokaishi, Vol. 20, No. 7, pages 300 to 308 (1984) may be used.

The ethylenically unsaturated bond-containing compound is ordinarily used in an amount ranging from 5 to 80% by weight, preferably from 30 to 70% by weight, based on the total weight of the photosensitive layer.

### [Polymer binder]

In the photosensitive layer according to the invention, a polymer binder, preferably a polymer binder having a crosslinkable group in a side chain is used.

The term "crosslinkable group" as used herein means a group capable of crosslinking the polymer binder in the process of a radical polymerization reaction which is caused in the photosensitive layer, when the photosensitive lithographic printing plate is exposed to light. The crosslinkable group is not particularly restricted as long as it has such a function and includes, for example, an ethylenically unsaturated bond group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bond group is preferable, and functional groups represented by formulae (1) to (3) shown below are particularly preferable.

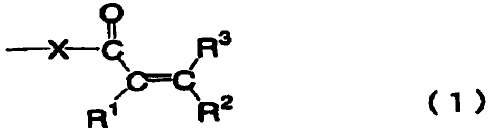

In formula (1), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

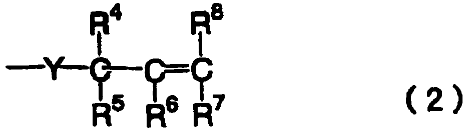

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable. Examples of the substituent introduced include those described in Formula (1).

Y represents an oxygen atom, a sulfur atom or -N(R¹²)-, and R¹² has the same meaning as R¹² defined in Formula (1). Preferred examples for R¹² are also same as those described in Formula (1).

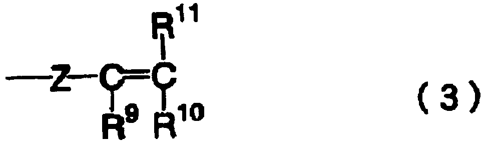

In formula (3), R⁹ to R¹¹ each independently represents a hydrogen atom or a monovalent organic group. R⁹ preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, -N(R¹³)- or a phenylene group which may have a substituent. R¹³ preferably includes an alkyl group which may have a substituent Among them, a methyl group, an ethyl group or an isopropyl group is preferable because of high radical reactivity.

The polymer binder having a crosslinkable group in the side chain according to the invention not only functions as a film-forming agent of the photosensitive layer but also is preferably a polymer which is soluble or swellable in alkali water since it is needed to be dissolved in a developer, preferably an alkali developer. Therefore, it is preferred that the polymer binder according to the invention has an alkali-soluble group, for example, a carboxy group, in the side chain in addition to the crosslinkable group.

In the case where the polymer binder having a crosslinkable group in the side chain is a water-soluble polymer, it is possible to conduct water development.

Examples of the polymer binder according to the invention include (meth)acrylic acid copolymers, itaconic acid copolymers, crotonic acid copolymers, maleic acid copolymers and partially esterified maleic acid copolymers each having a crosslinkable group, for example, an allyl group or a (meth)acryloyl group in the side chain thereof as described in JP-A-59-53836 and JP-A-59-71048.

Also, polyurethanes, acid cellulose derivatives and adducts between an addition polymer having a hydroxy group and a cyclic acid anhydride, each having the crosslinkable group and carboxy group in the side chain are useful as the polymer binder according to the invention.

Of the polymers, the polyurethane resins and (meth)acrylic resins are more preferable. In particular, the polyurethane resins are preferable from the standpoint that development damage in the exposed area can be prevented without accompanying with decrease in developing property in the unexposed area so that both good stain resistance and high printing durability can be achieved, even when an acid value of the photosensitive layer is low.

The polyurethane resin having a crosslinkable group in the side chain thereof is described in more detail below.

The polyurethane resin having a crosslinkable group in the side chain thereof particularly preferably used in the invention can be obtained by a polyaddition reaction of (i) a diisocyanate compound, (ii) a diol compound having at least one carboxy group, (iii) a diisocyanate compound having a crosslinkable group, and if desired, (iv) a diol compound containing no carboxy group.

The diisocyanate compound and diol compound which are starting materials of the polyurethane resin will be described in more detail below.

### (i) Diisocyanate compound

Examples of the diisocyanate compound include diisocyanate compounds represented by the following formula (4):

OCN-L-NCO (4)

In formula (4), L represents a single bond or a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.

The diisocyanate compounds may be used individually or in combination of two or more thereof In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).

With respect to an amount of the diisocyanate compound used, a molar ration of the diisocyanate compound to the diol compound is preferably from 0.8 to 1.2, and more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal

### (ii) Diol Compound Having At Least One Carboxy Group

The diol compound having at least one carboxy group includes diol compounds represented by formulae (5), (6) and (7) shown below and/or a compound obtained by ring opening of a tetracarboxylic acid dianhydride with a diol compound.

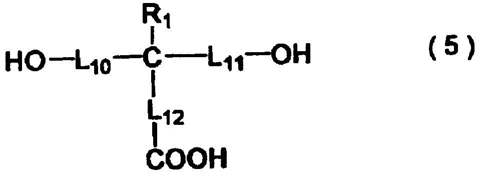

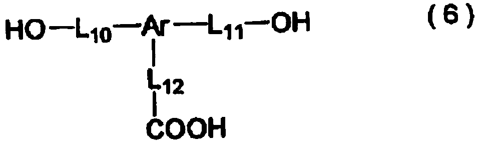

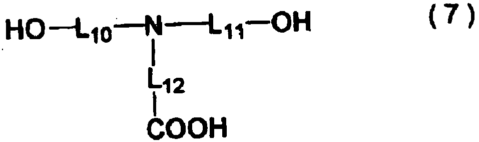

In the formulae, R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)); and preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁₁, L₁₀, L₁₁ and L₁₂ may be taken together to form a ring. Ar represents a trivalent aromatic hydrocarbon group which may have substituent, and preferably an aromatic group having from 6 to 15 carbon atoms.

Specific examples of the diol compound having a carboxy group represented by formula (5), (6) or (7) include the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

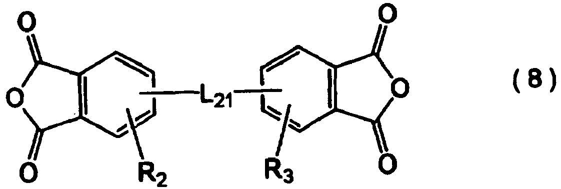

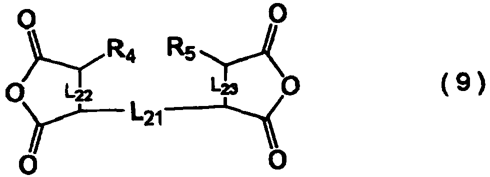

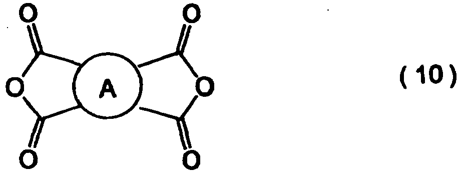

In the formulae, L₂₁ represents a single bond, a divalent aliphatic or aromatic hydrocarbon group which may have a substituent (preferably, for example, an alkyl group, an aralkyl group, an aryl group, an alkoxy group, a halogeno group, an ester group or an amido group), -CO-, -SO-, -SO₂-, -O- or -s-; and preferably a single bond, a divalent aliphatic hydrocarbon group having from 1 to 15 carbon atoms, -CO-, -SO₂-, -O- or -s-. R₂ and R₃, which may be the same or different, each represents a hydrogen atom, an alkyl group, an aralkyl group, an aryl group, an alkoxy group or a halogeno group; and preferably a hydrogen atom, an alkyl group having from 1 to 8 carbon atoms, an aryl group having from 6 to 15 carbon atoms, an alkoxy group having from 1 to 8 carbon atoms or a halogeno group. Alternatively, two of L₂₁, R² and R³ may be combined with each other to form a ring. R₄ and R₅, which may be the same or different, each represents a hydrogen atom, an alkyl group, an aralkyl group, an aryl group or a halogeno group; and preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group; and preferably a single bond, a double bond or a methylene group. A represents a monocyclic or polycyclic aromatic ring; and preferably an aromatic ring having from 6 to 18 carbon atoms.

Specific examples of the compound represented by formula (8), (9) or (10) include the following compounds.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'(alkylphosphoryldiphenylene)-bis(iminocarbonyl)] diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxylic acid dihydride (Epicron B-4400, produced by Dainippon Ink and Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxy group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound; and
b) Method wherein an alcohol-terminated urethane compound obtained by reacting the diisocyanate compound under excess of the diol compound is reacted with the tetracarboxylic acid dianhydride.

Of the diol compounds having at least one carboxylic group, the compounds represented by formula (5) are more preferable because of high solvent solubility and ease of synthesis. The diol compound having at least one carboxylic group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, and most preferably from 0.6 to 1.2 meq/g, of the carboxy group. Therefore, although the content of the structure derived from the diol compounds having at least one carboxylic group in the polyurethane resin binder can be appropriately determined after considering a number of the carboxy group in the diol compound, other diol compound used in combination, an acid value or molecular weight of the resulting polyurethane resin binder, a composition or pH of developer and the like, it is, for example, ordinarily from 5 to 45% by mole, preferably from 10 to 40% by mole, and more preferably from 15 to 35% by mole.

### (iii) Diisocyanate Compound Having Crosslinkable Group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

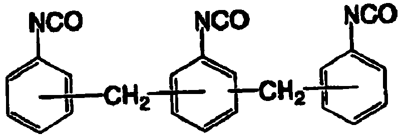

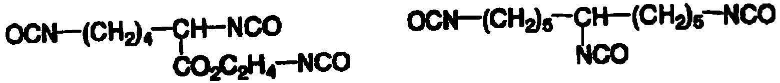

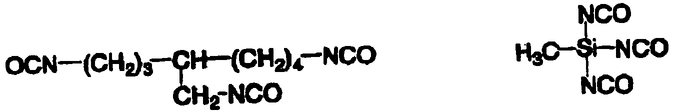

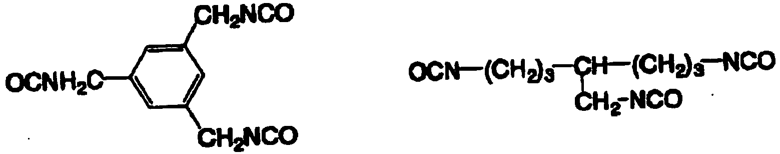

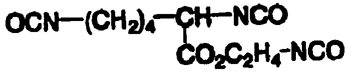

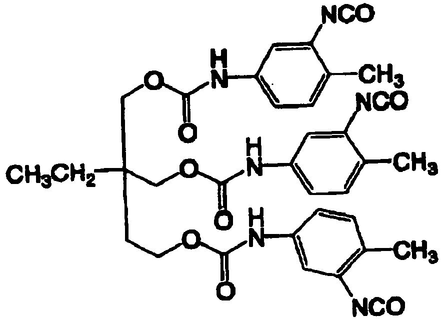

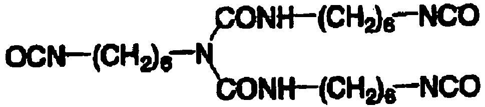

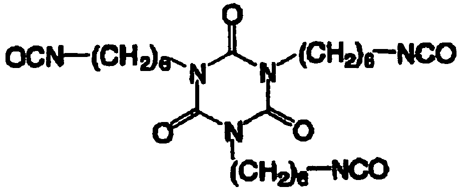

Examples of the monofunctional alcohol or monofunctional amine compound having a crosslinkable group are set forth below, but the invention should not be construed as being limited thereto. 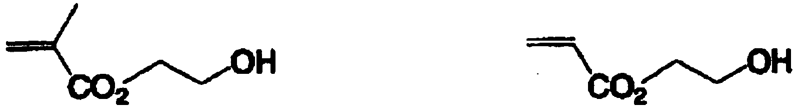 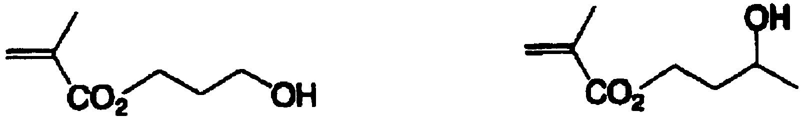 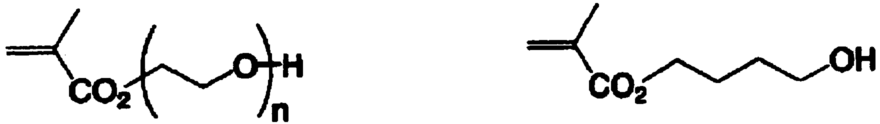 n is an integer of 2 to 10.

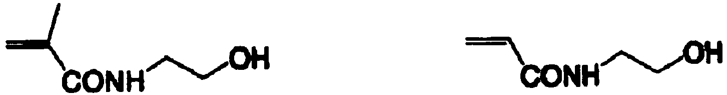

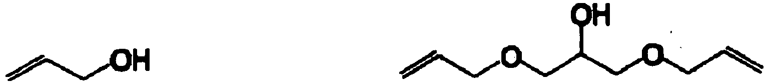

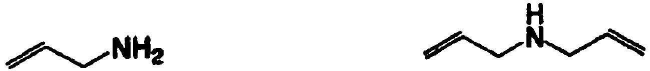

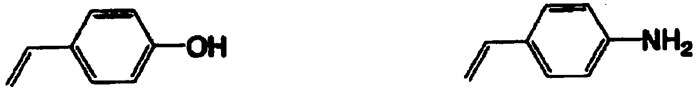

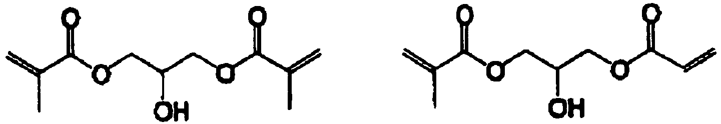

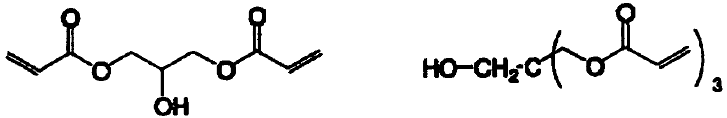

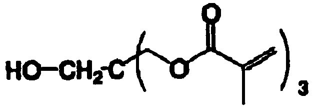

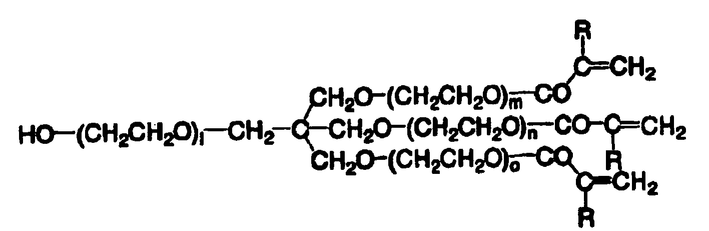

R is a hydrogen atom or a methyl group.

l, m, n and o each represents an integer of 1 to 20.

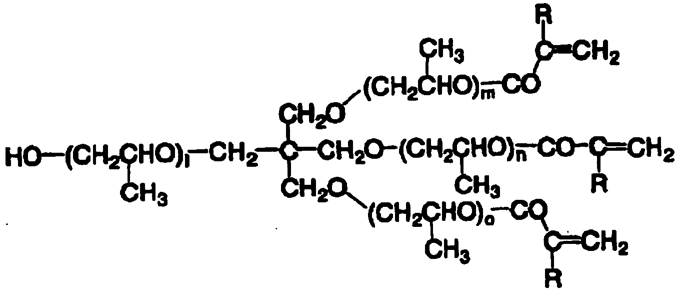

R is a hydrogen atom or a methyl group.

l, m, n and o each represents an integer of 1 to 20.

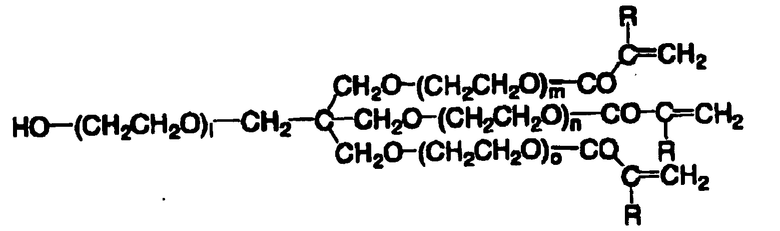

R is a hydrogen atom or a methyl group.

l, m, n and o each represents an integer of 1 to 20.

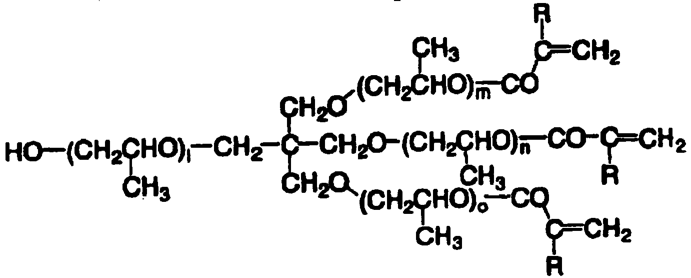

R is a hydrogen atom or a methyl group.

l, m, n and o each represents an integer of 1 to 20.

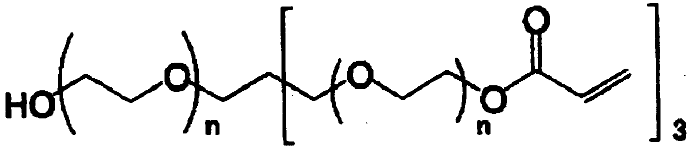

n is an integer of 1 to 20.

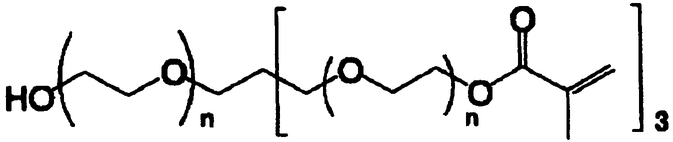

n is an integer of 1 to 20.

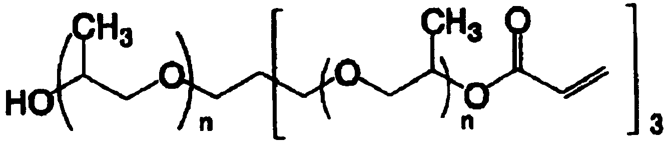

n is an integer of 1 to 20.

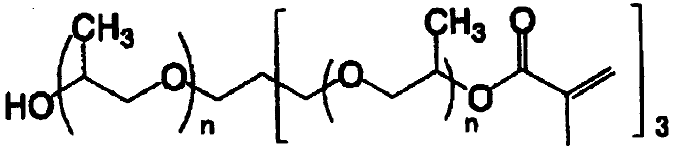

n is an integer of 1 to 20.

In order to introduce a crosslinkable group into the side chain of the polyurethane resin, a method of using as a raw material for the production of polyurethane resin, the diisocyanate compound having the crosslinkable group in the side chain is preferable. Specific examples of the diisocyanate compound having a crosslinkable group in the side chain obtained by an addition reaction of a triisocyanate compound with one equivalent of a monofunctional alcohol or monofunctional amine compound having the crosslinkable group are set forth below, but the invention should not be construed as being limited thereto.

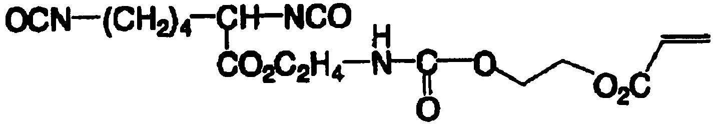

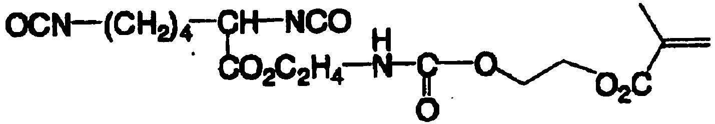

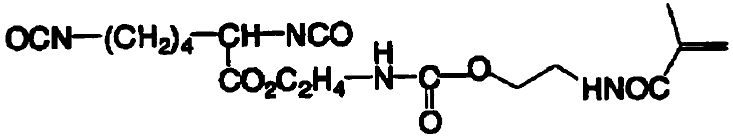

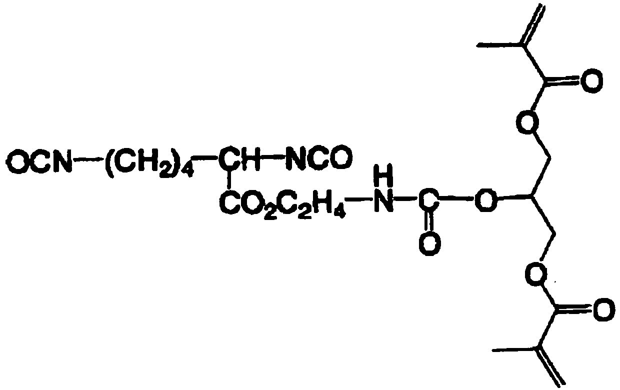

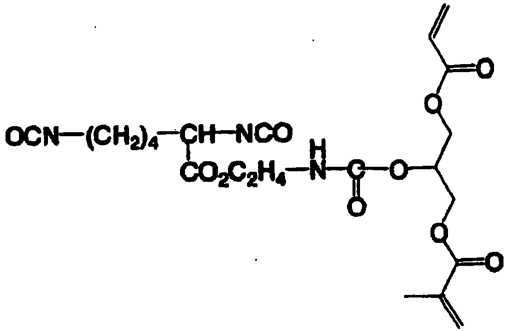

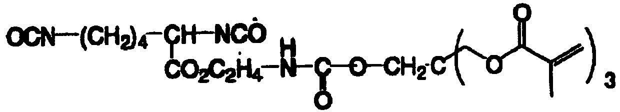

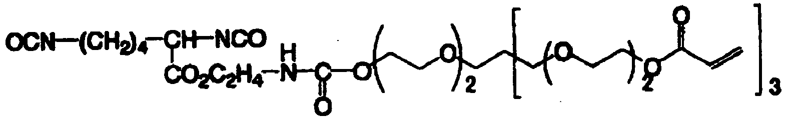

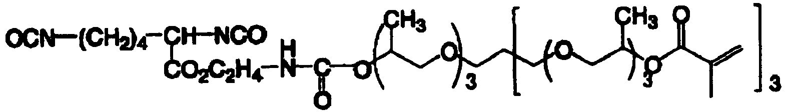

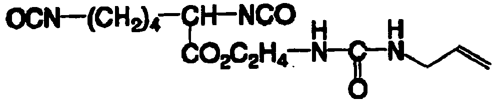

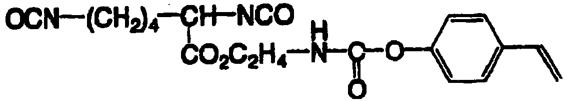

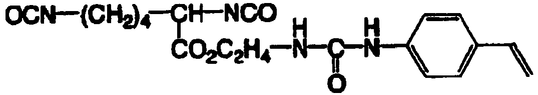

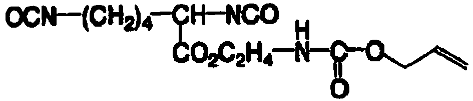

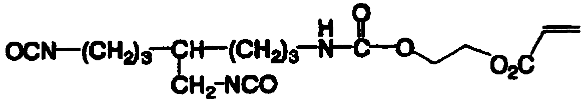

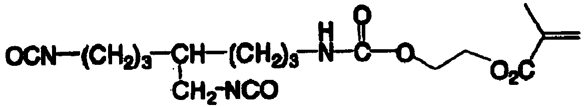

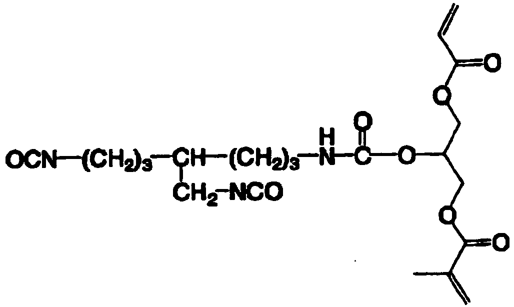

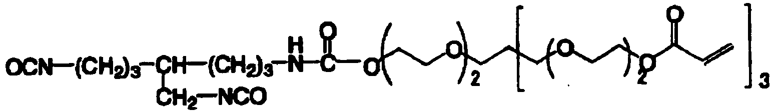

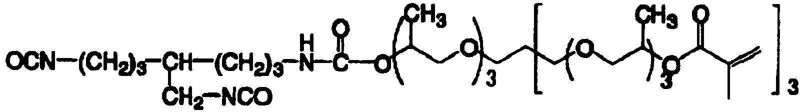

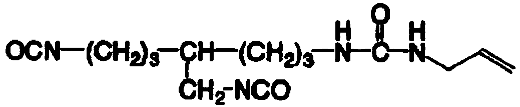

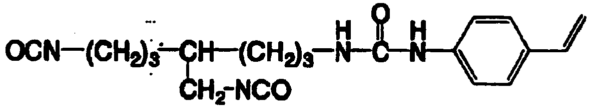

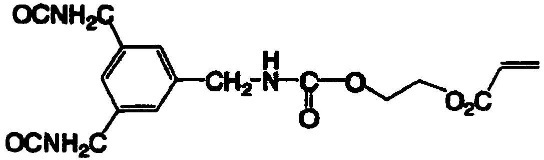

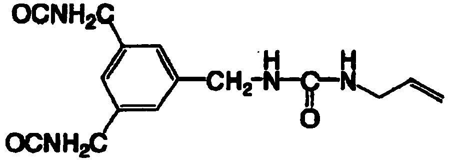

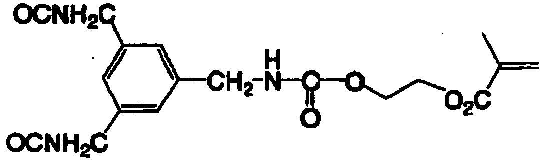

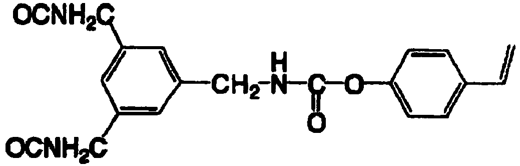

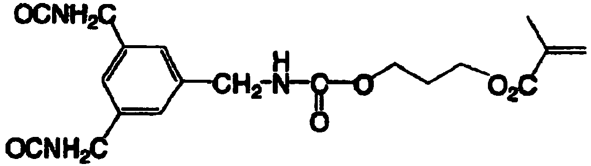

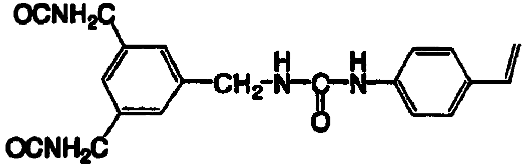

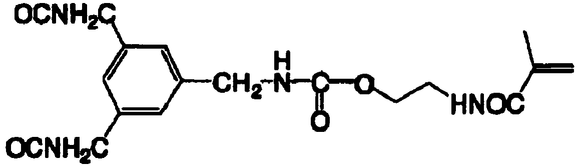

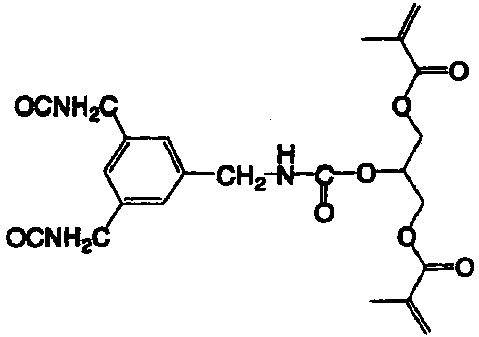

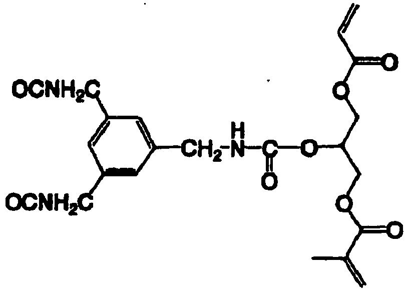

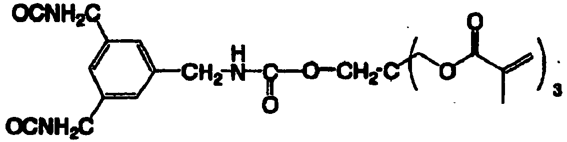

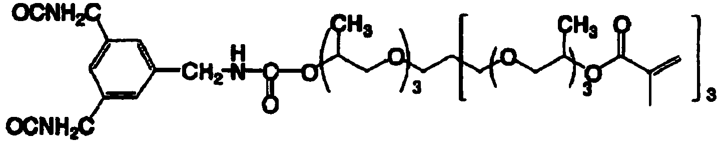

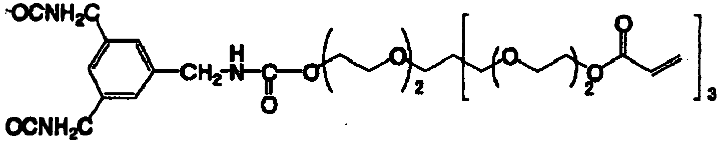

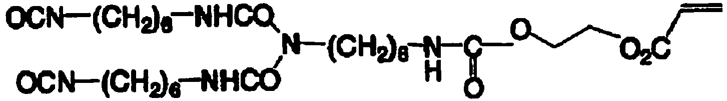

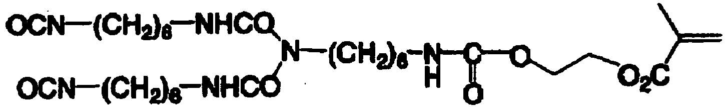

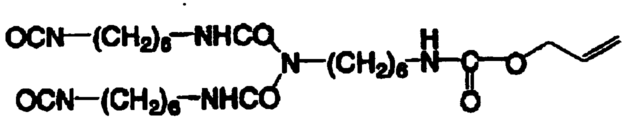

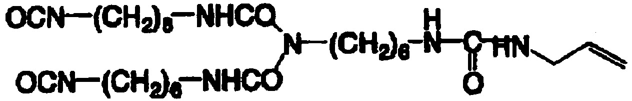

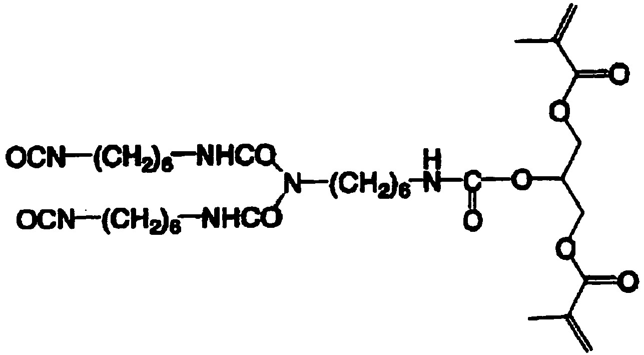

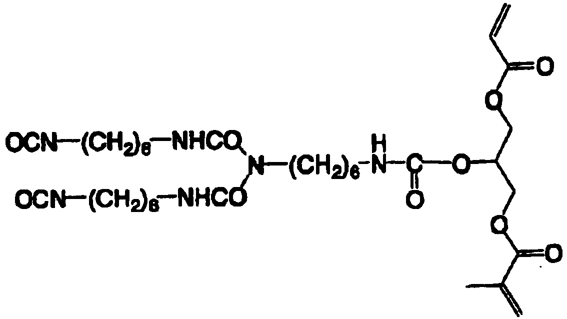

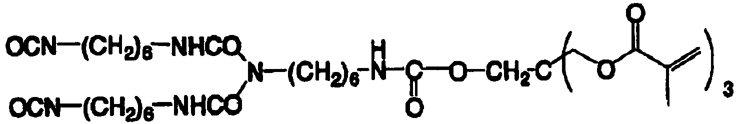

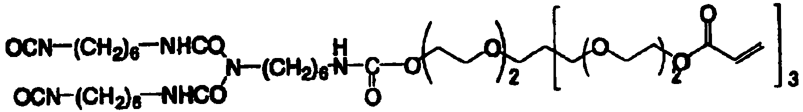

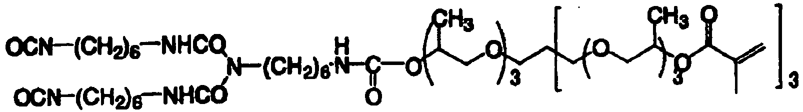

### (iv) Diol Compound not having carboxyl group

A method of using a diol compound having a crosslinkable group in the side chain as a raw material for the production of polyurethane resin is preferable as well as the method described above for the purpose of introducing the crosslinkable group into the side chain of the polyurethane resin. Such a diol compound may be a commercially avairable compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto.

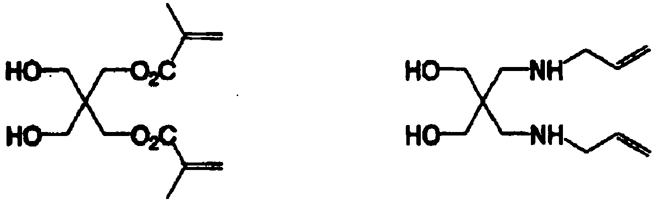

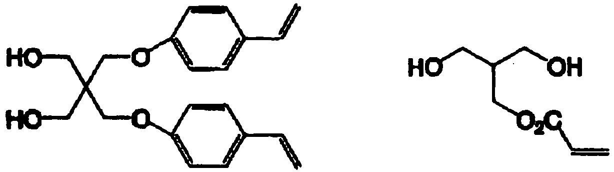

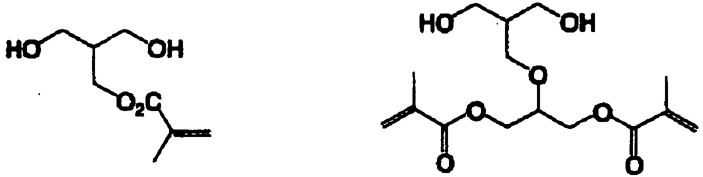

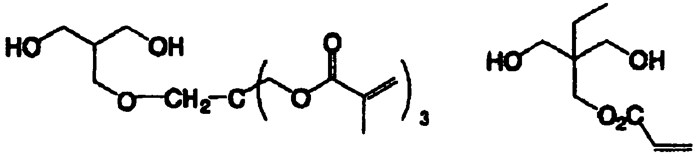

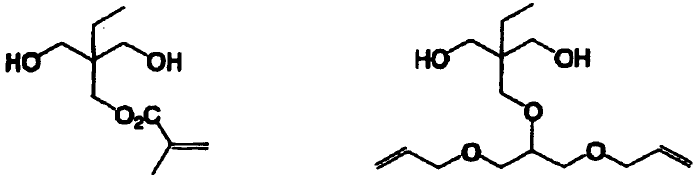

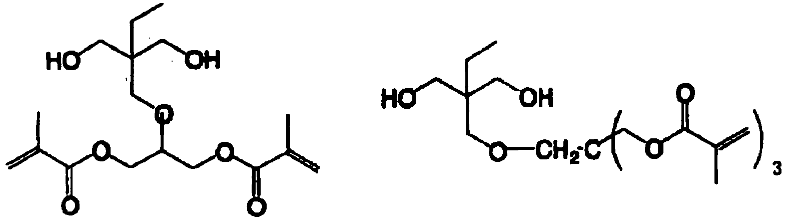

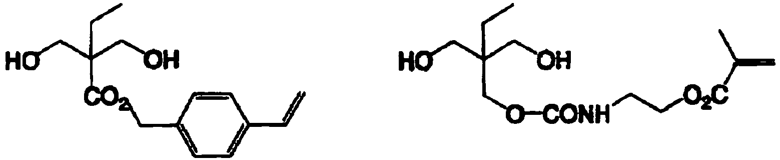

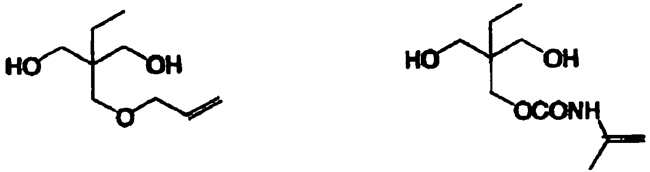

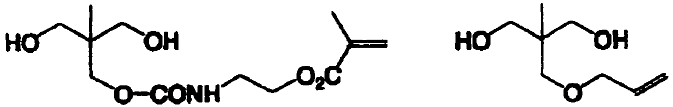

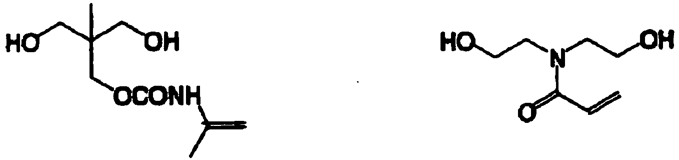

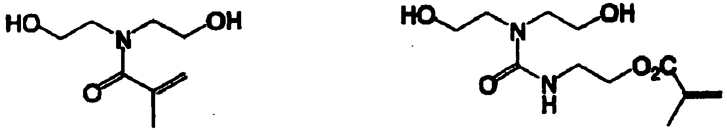

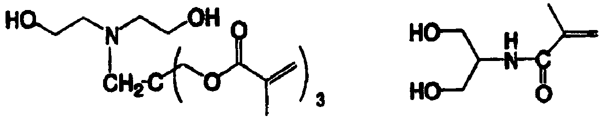

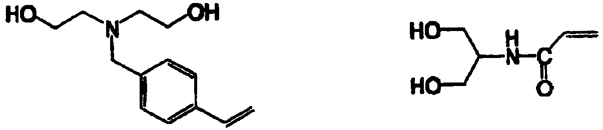

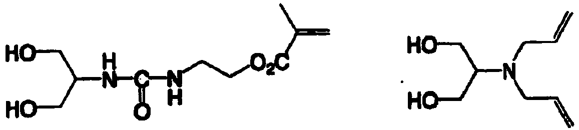

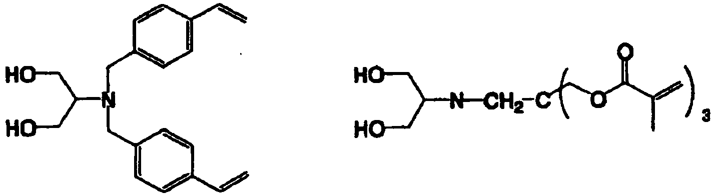

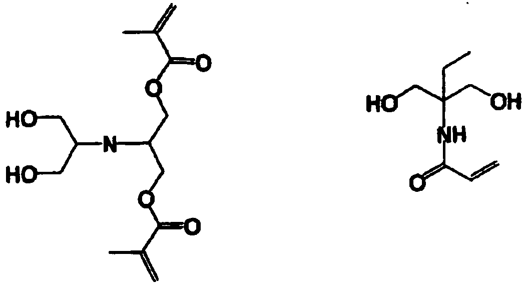

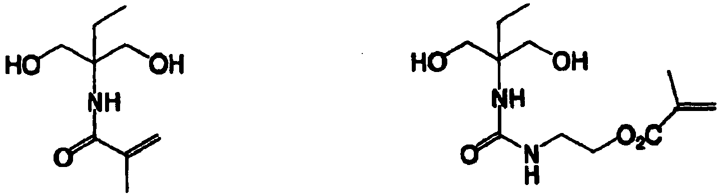

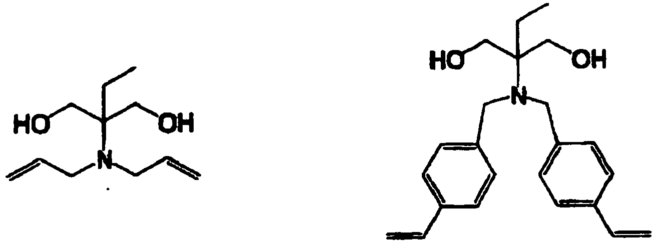

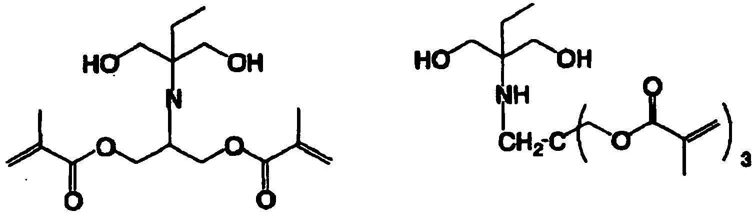

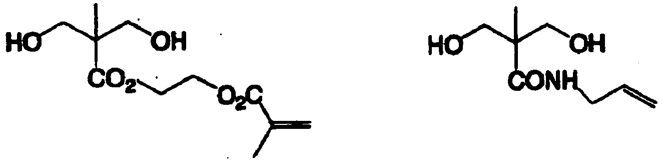

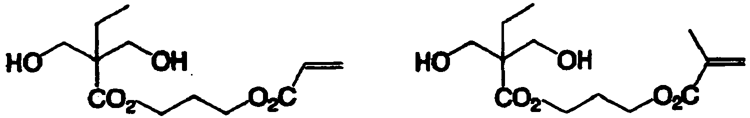

Another examples of the other diol compound include ethylene glycol compounds represented by the following formula (A'):

HO-(CH₂CH₂O)ₙ-H (A')

In the formula, n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3 -pentanediol, 1,4-bis-p-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by the following formulae (A), (B), (C), (D) and (E) are preferably used.

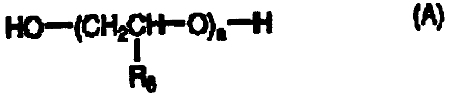

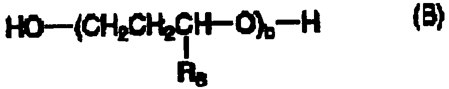

**HO-(CH₂CH₂CH₂CH₂-O)_{c}-H** **(C)**

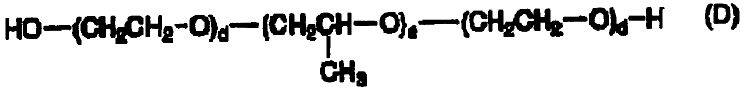

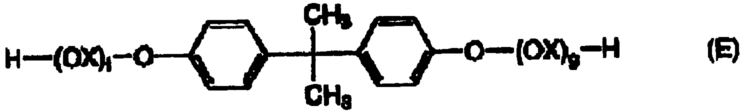

In the formulae, R₆ represents a hydrogen atom or a methyl group, provided that R₆ in formula (A) represents a methyl group. X represents a group shown below.

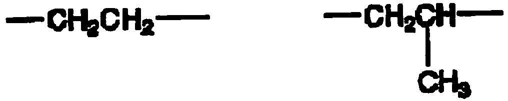

a, b, c, d, e, f and g each represents an integer of 2 or more, and preferably an integer of 2 to 100.

Polyester diol compounds represented by formulae (11) and (12) shown below are also enumerated as specific examples.

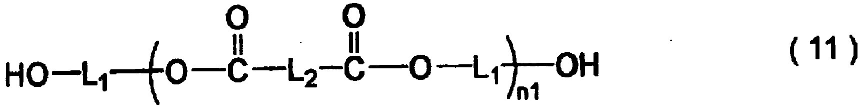

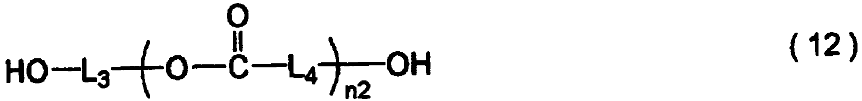

In the formulae, L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, and preferably an integer of 2 to 100.

Polycarbonate diol compounds represented by formula (13) shown below are also enumerated as specific examples.

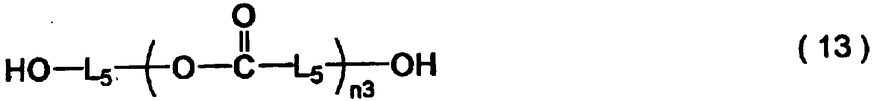

In the formula, L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, and preferably an integer of 2 to 100.

Specific examples of the diol compound represented by formula (11), (12) or (13) include those shown below. In the specific examples, n represents an integer of 2 or more.

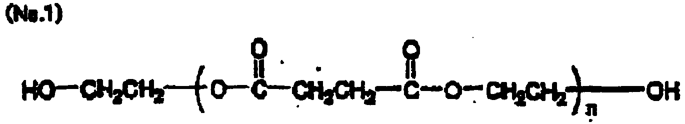

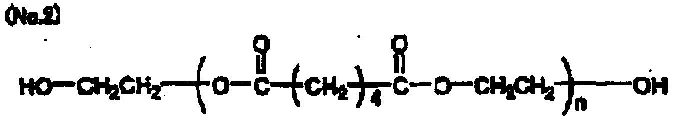

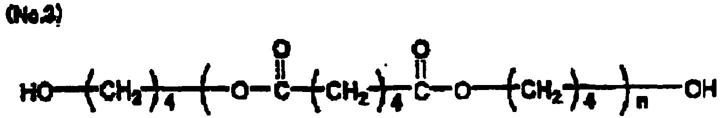

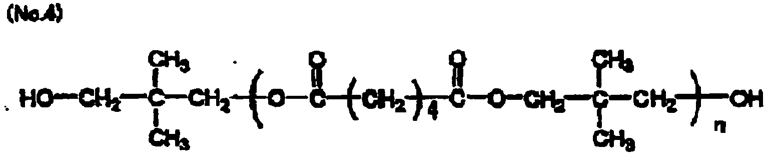

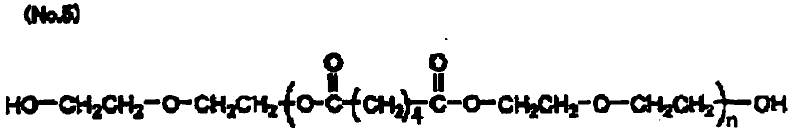

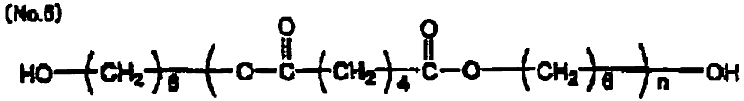

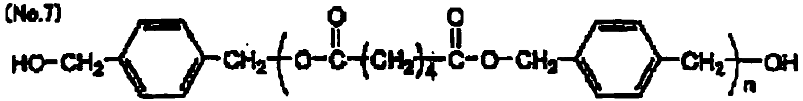

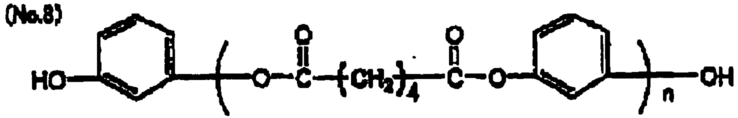

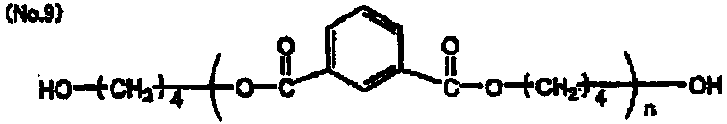

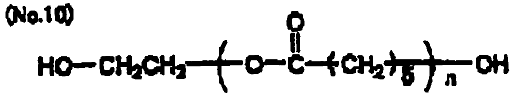

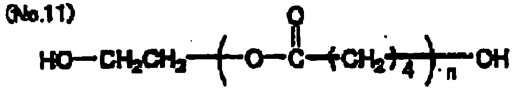

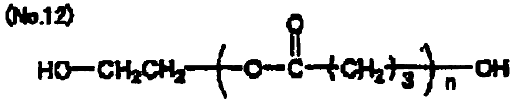

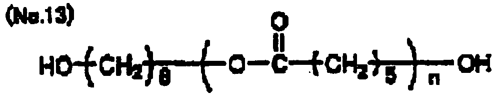

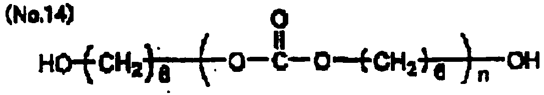

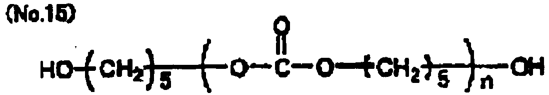

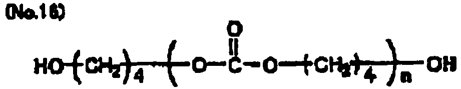

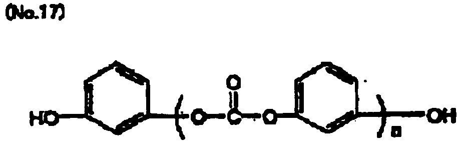

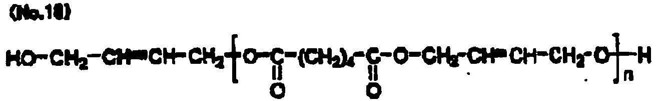

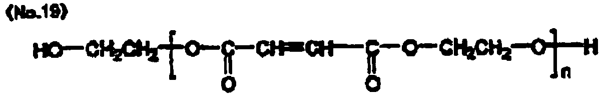

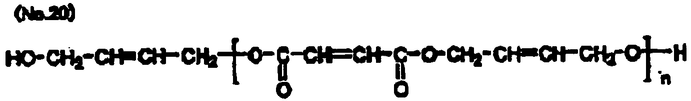

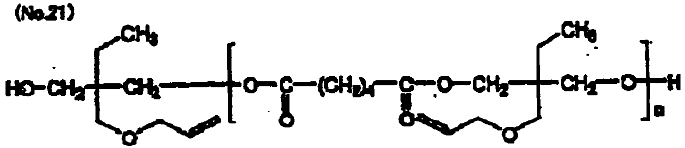

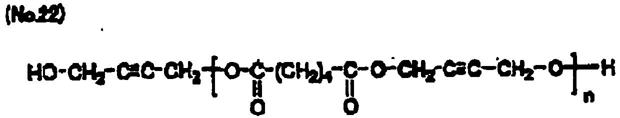

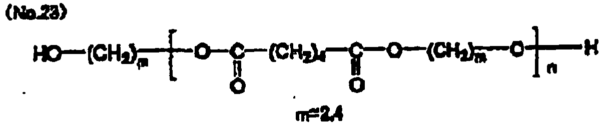

Moreover, a diol compound that does not have a carboxy group and that may have other functional group which does not react with the isocyanate group may be used.

Examples of such a diol compound include those represented by formulae (14) and (15) shown below.

HO-L₆-O-CO-L₇-CO-O-L₆-OH (14)

HO-L₇-CO-O-4-OH (15)

In the formulae, L₆ and L₇, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₆ and L₇ each may have other functional group which does not react with the isocyanate group, for example, a carbonyl group, an ester group, a urethane group, an amido group or a ureido group, if desired. Alternatively, L₆ and L₇ may be combined with each other to form a ring.

Specific examples of the diol compound represented by formula (14) or (15) include those shown below.

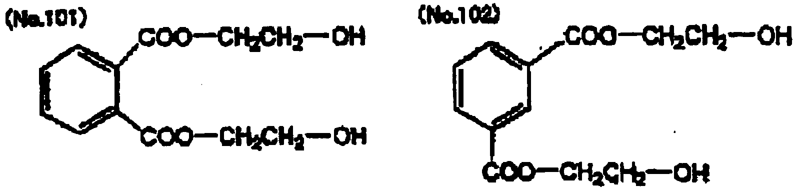

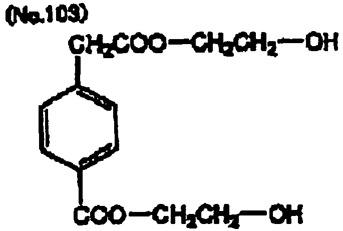

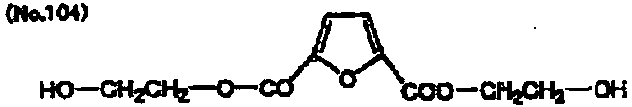

**(No.105)** **HO-CH₂CH₂-O-CO-CH=CH-COO-CH₂CH₂-OH**

**(No.106)** **HO-CH₂CH₂-O-COC₁₁H₂₂COO-CH₂CH₂-OH**

**(No.107)** **HO-CH₂CH₂-O-COC₁₂H₂₄COO-CH₂H₂-OH**

**(No.108)** **HO-CH₂CH₂-O-COC₁₄H₂₆COO-CH₂CH₂-OH**

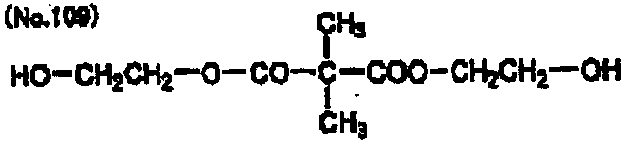

**(No.110)** **HO-CH₂CH₂-O-CO-C=C-COO-CH₂CH₂-OH**

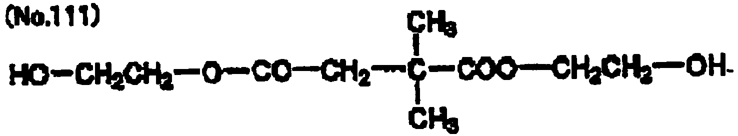

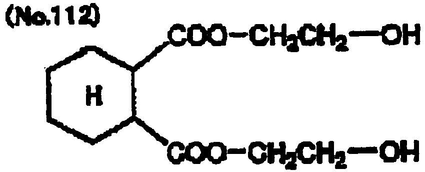

**(No.113)** **HO-CH₂CH₂-O-CO-CH₂-O-CH₂-COO-CH₂CH₂-OH**

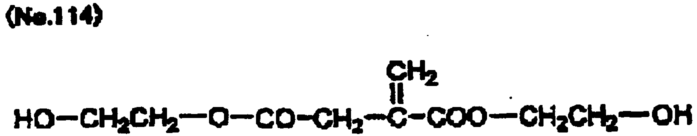

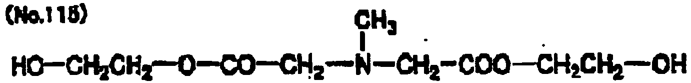

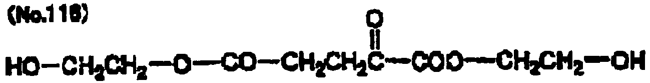

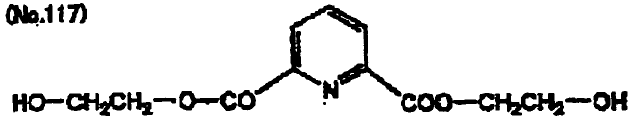

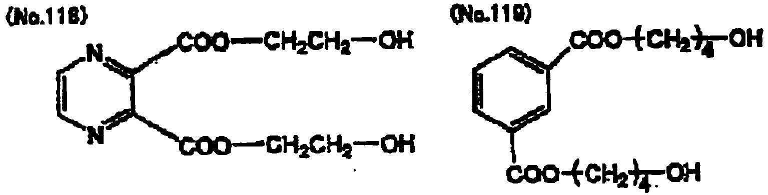

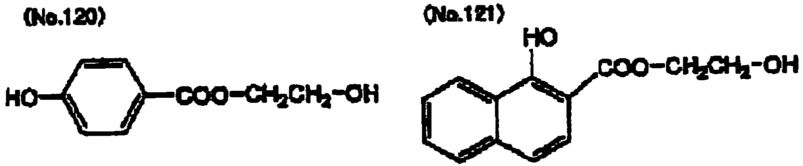

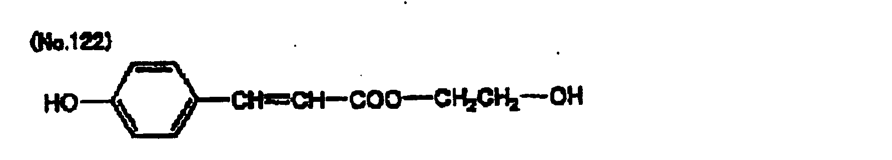

**(No.123)** **HO-CH₂CH₂-COO-CH₂CH₂-OH**

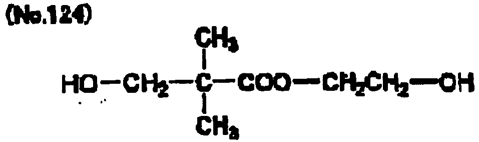

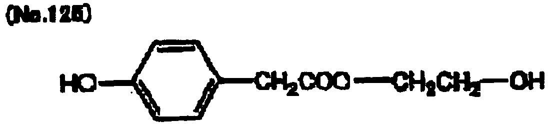

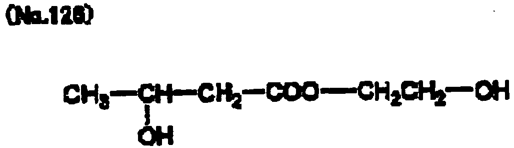

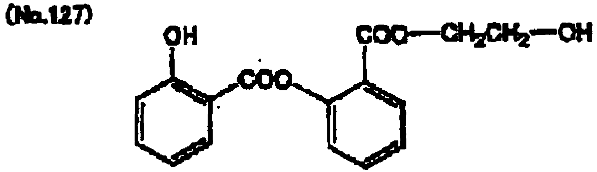

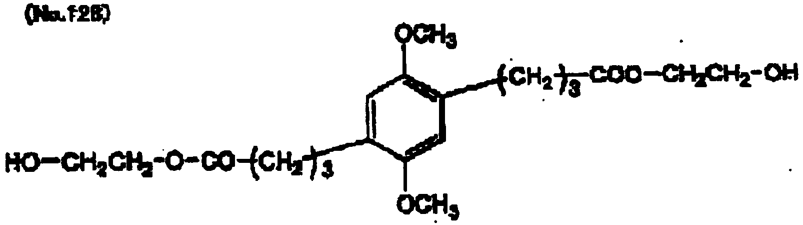

Moreover, diol compounds shown below are also preferably used.

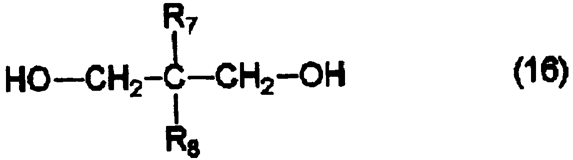

**HO-CH₂-C≡C-CH₂-OH** **(17)**

**HO-CH₂-CH=CH=CH-CH₂-OH** **(18)**

In the formulae, R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

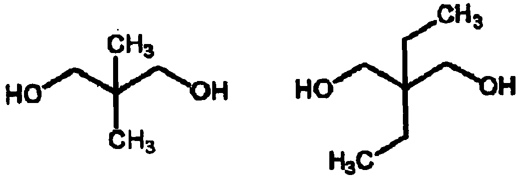

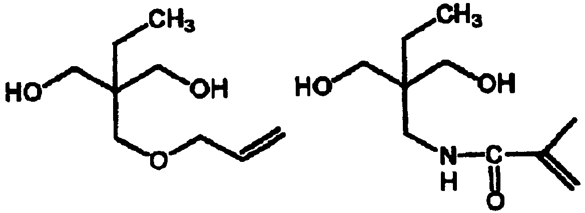

Example of the diol compound represented by formula (17) includes 2-butyne-1,4-diol. Examples of the diol compound represented by formula (18) include cis-2-butene-1,4-diol and trans-2-butene-1,4-diol.

Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In the formulae, L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below. 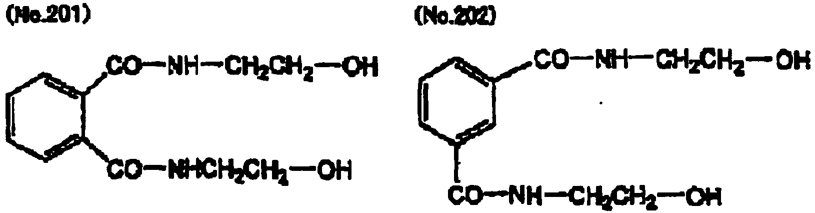
**(No.203)**

   **HO-CH₂CH₂-NH-CO-CH=CH-CO-NH-CH₂CH₂-OH**
**(No.204)**

   **HO-CH₂CH₂-NH-CO-C≡C-CO-NH-CH₂CH₂-OH** 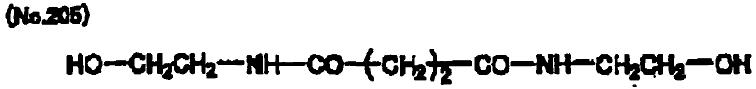 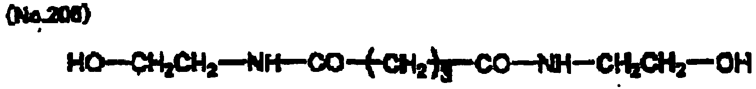 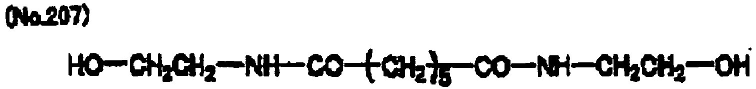 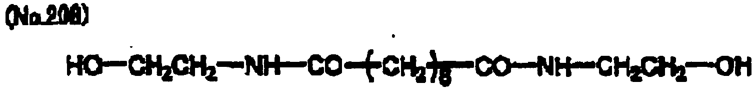 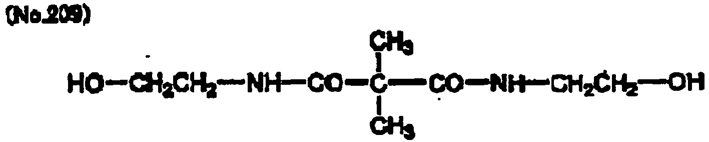 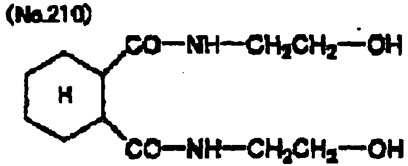 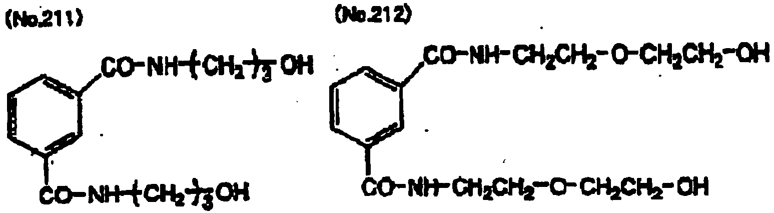 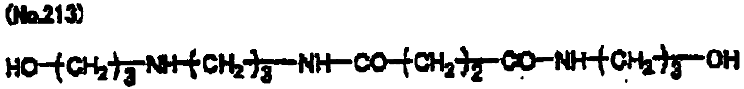 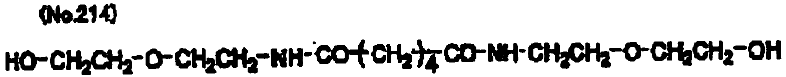
**(No.215)**

   **HO-CH₂CH₂-NH-CO-CH₂-O-CH₂-CO-NH-CH₂CH₂-OH** 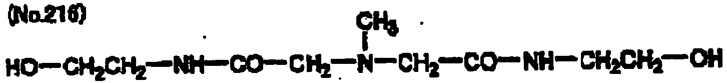 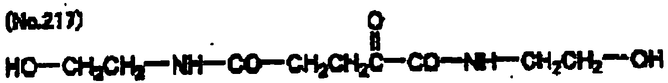
**(No.218)**

   **HO-CH₂CH₂-NH-CO-CH₂-S-CH₂-CO-NH-CH₂CH₂-OH**

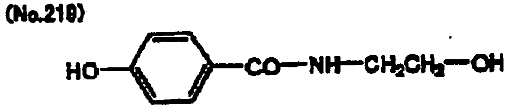

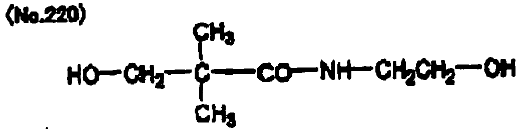

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In the formulae, L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechoL 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carboxymethoxyresorcine, 2-methylresorcine, 5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. Diol compounds shown below are also preferably used.

### (v) Other Amino Group-Containing Compound

In the polyurethane resin binder according to the invention, an amino group-containing compound represented by formula (31) or (32) shown below may be used together to react with the diisocyanate compound, thereby forming a urea structure to incorporate into the polyurethane resin.

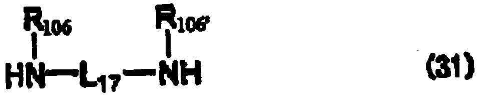

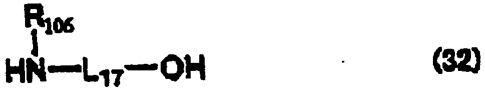

In the formulae, R₁₀₆ and R₁₀₆', which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxy group); and preferably a hydrogen atom, an alkyl group having from 1 to 8 carbon atoms or an aryl group having from 6 to 15 carbon atoms, each of which may have a carboxy group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxy group). L₁₇ may have other functional group which does not react with the isocyanate group, for example, a carbonyl group, an ester group, a urethane group or an amido group, if desired. Alternatively, two of R₁₀₆, L₁₇ and R₁₀₆ may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine); aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2, 5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

A polyurethane resin obtained by introducing a crosslinkable group into polyurethane having a carboxy group by a polymer reaction as described in JP-A-2003-270775 may also be used as the polymer binder according to the invention as well as the above-described polyurethane resin obtained by introducing a crosslinkable group into the side chain at the synthesis of polyurethane.

Now, the (meth)acrylic resin having a crosslinkable group in the side chain thereof is described in detail below.

The (meth)acrylic resin having a crosslinkable group in the side chain thereof for use in the invention is preferably a resin having a repeating unit represented by formula (i) shown below in view of the developing property.

The resin having a repeating unit represented by formula (i) is hereinafter appropriately referred to as a specific (meth)acrylic resin and will be described in detail below.

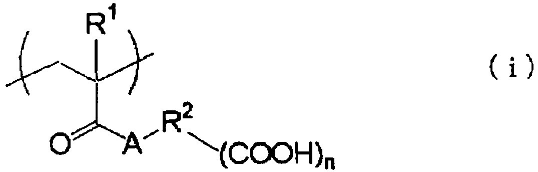

In formula (i), R¹ represents a hydrogen atom or a methyl group, R² represents a linking group constructed from one or more atoms selected from the group consisting of a carbon atom, a hydrogen atom, an oxygen atom, a nitrogen atom and a sulfur atom, A represents an oxygen atom or NR³-, wherein R³ represents a hydrogen atom or a monovalent hydrocarbon group having from 1 to 10 carbon atoms, and n represents an integer of 1 to 5.

R¹ in formula (i) represents a hydrogen atom or a methyl group, particularly preferably a methyl group.

The linking group represented by R² in formula (i) is constructed from one or more atoms selected from the group consisting of a carbon atom, a hydrogen atom, an oxygen atom, a nitrogen atom and a sulfur atom. A number of atoms included in the linking group is preferably from 1 to 82 exclusive of substituent. More particularly, the number of atoms constituting a main skeleton of the linking group represented by R² is preferably from 1 to 30, more preferably from 3 to 25, still more preferably from 4 to 20, most preferably from 5 to 10. The term "main skeleton of the linking group" as used herein means an atom or atomic group used only for linking A to the terminal COOH in formula (i) and, in the case where a plurality of linking routes exist, an atom or atomic group constituting a linking route where the number of atoms included is minimal. Therefore, when the linking group contains a cyclic structure, the number of atoms to be included may vary depending on the bonding positions (for example, o-, m- or p-position).

Specific examples of the linking group include an alkylene group, a substituted alkylene group, an arylene group and a substituted arylene group. The linking group may have a structure wherein a plurality of such divalent groups is connected to each other via an amido bond or an ester bond.

Examples of the linking group having a chain structure include an ethylene group and a propylene group. A structure wherein such alkylenes are connected with each other via an ester bond is also preferably illustrated.

Of these, the linking group represented by R² in formula (i) is preferably an (n+1)-valent hydrocarbon group having an aliphatic cyclic structure containing from 3 to 30 carbon atoms. Specific examples thereof include (n+1)-valent hydrocarbon group formed by removing (n+1) hydrogen atoms on an appropriate carbon atom or atoms constituting a compound having an aliphatic cyclic structure, for example, cyclopropane, cyclopentane, cyclohexane, cycloheptane, cyclooctane, cyclodecane, dicyclohexyl, tercyclohexyl or norbornane, which may be substituted with one or more appropriate substituents. In such a case, R² preferably contains from 3 to 30 carbon atoms including the substituent.

Any of one or more carbon atoms of the compound constituting the aliphatic cyclic structure may be appropriately replaced by a hetero atom selected from a nitrogen atom, an oxygen atom and a sulfur atom. In view of printing durability, R² is preferably a (n+1)-valent hydrocarbon group having an aliphatic cyclic structure which contains two or more rings and has from 5 to 30 carbon atoms and may have a substituent, for example, condensed polycyclic aliphatic hydrocarbon, bridged alicyclic hydrocarbon, spiro aliphatic hydrocarbon or aliphatic hydrocarbon ring assembly (wherein a plurality of rings are connected to each other through a bond or a linking group). In such a case, also, the number of carbon atoms is the number of carbon atoms including the carbon atom in the substituent.

As the linking group represented by R², particularly, the linking group wherein the number of atoms constituting the main skeleton thereof is from 5 to 10 is preferable. From the structural view point, the linking group having an ester bond or linking group having the cyclic structure as described above is preferable.

Examples of the substituent to be introduced into the linking group represented by R² include a monovalent non-metallic atomic group exclusive of hydrogen, for example, a halogen atom (e.g., -F, -Br, -Cl, -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group and a conjugate base group thereof, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group (-SO₂NHSO₂(alkyl)) and a conjugate base group thereof, an N-arylsulfonylsulfamoyl group (-SO₂NHSO₂(aryl)) and a conjugate base group thereof, an N-alkylsulfonylcarbamoyl group (-CONHSO₂(alkyl)) and a conjugate base group thereof, an N-arylsulfonylcarbamoyl group (-CONHSO₂(aryl)) and a conjugate base group thereof, an alkoxysilyl group (-Si(O-alkyl)₃), an aryloxysilyl group (-Si(O-aryl)₃), a hydroxysilyl group (-Si(OH)₃) and a conjugate base group thereof, a phosphono group (-PO₃H₂) and a conjugate base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof, a monoarylphosphono group (-P4₃H(aryl)) and a conjugate base group thereof, a phosphonoxy group (-OPO₃H₂) and a conjugate base group thereof, a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof, a monoarylphosphonoxy group (-OPO₃H(aryl)) and a conjugate base group thereof, a cyano group, a nitro group, a dialkylboryl group (-B(alkyl)₂), a diarylboryl group (-B(aryl)₂), an alkylarylboryl group (-B(alkyl)(aryl)), a dihydroxyboryl group (-B(OH)₂) and a conjugate base group thereof, an alkylhydroxyboryl group (-B(alkyl)(OH)) and a conjugate base group thereof, an arylhydroxyboryl group (-B(aryl)(OH)) and a conjugate base group thereof, an aryl group, an alkenyl group and an alkynyl group.

In the photosensitive lithographic printing plate according to the invention, a substituent having a hydrogen atom capable of forming a hydrogen bond and particularly, a substituent having an acidity of an acid dissociation constant (pKa) smaller than that of carboxylic acid is not preferred because such a substituent tends to deteriorate the printing durability, although depending on design of the photosensitive layer. On the other hand, a halogen atom or a hydrophobic substituent, for example, a hydrocarbon group (e.g., an alkyl group, an aryl group, an alkenyl group or an alkynyl group), an alkoxy group or an aryloxy group is preferred because it tends to improve printing durability. In particular, in the case where the cyclic structure is a monocyclic aliphatic hydrocarbon of 6-membered or less, for example, cyclopentane or cyclohexane, it is preferred for the cyclic structure to have such a hydrophobic substituent. The substituents may be connected to each other or the substituent may be connected to the hydrocarbon group to which it is connected to form a ring. The substituent may be further substituted.

R³ in the case where A in formula (i) represents -NR³- represents a hydrogen atom or a monovalent hydrocarbon group having from 1 to 10 carbon atoms. Examples of the monovalent hydrocarbon group having from 1 to 10 carbon atoms represented by R³ include an alkyl group, an aryl group, an alkenyl group and an alkynyl group.

Specific examples of the alkyl group include a straight-chain, branched or cyclic alkyl group having from 1 to 10 carbon atoms, for example, a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group or a 2-norbornyl group.

Specific examples of the aryl group include an aryl group having from 1 to 10 carbon atoms, for example, a phenyl group, a naphthyl group or an indenyl group; and a heteroaryl group having from 1 to 10 carbon atoms and having one or more hetero atom selected from the group consisting of a nitrogen atom, an oxygen atom and a sulfur atom, for example, a furyl group, a thienyl group, a pyrrolyl group, a pyridyl group or a quinolyl group.

Specific examples of the alkenyl group include a straight-chain, branched or cyclic alkenyl group having from 1 to 10 carbon atoms, for example, a vinyl group, a 1-propenyl group, a 1-butenyl group, a 1-methyl-1-propenyl group, a 1-cyclopentenyl group or a 1-cyclohexenyl group.

Specific examples of the alkynyl group include an alkynyl group having from 1 to 10 carbon atoms, for example, an ethynyl group, a 1-propynyl group, a 1-butynyl group or a 1-octynyl group. Examples of the substituent which R³ may have are the same as those illustrated as substituents to be introduced into R², provided that the number of carbon atoms of R³ is from 1 to 10 including carbon atoms of the substituent.

A in formula (i) is preferably an oxygen atom or NH- due to ease of synthesis.

n in formula (i) represents an integer of 1 to 5 and, in view of the printing durability, n preferably represents 1.

Preferred specific examples of the repeating unit represented by formula (i) are set forth below, but the invention should not be construed as being limited thereto.

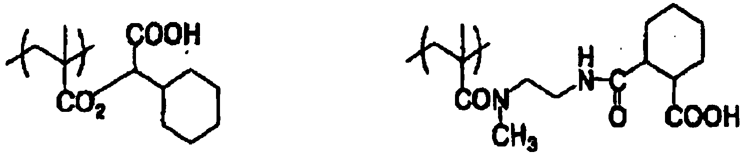

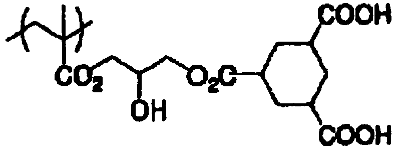

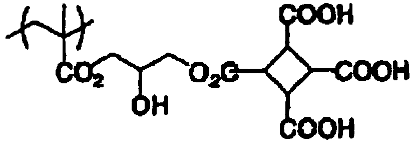

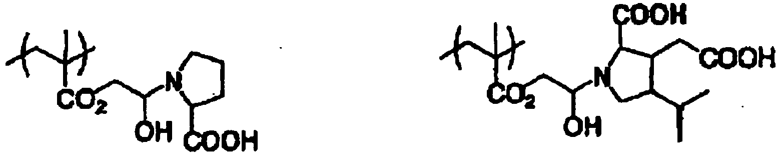

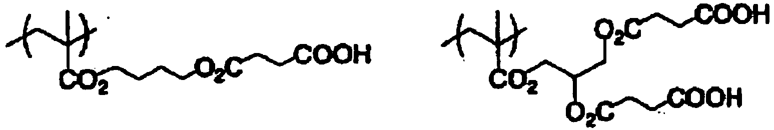

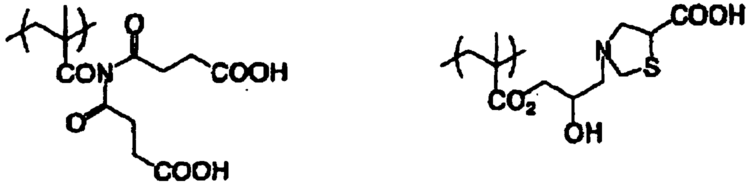

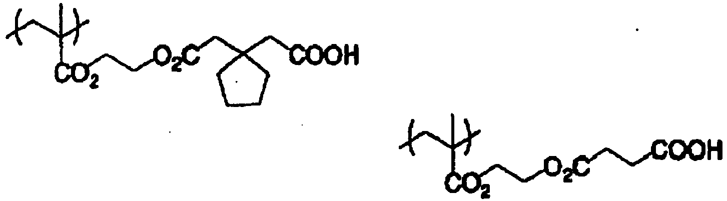

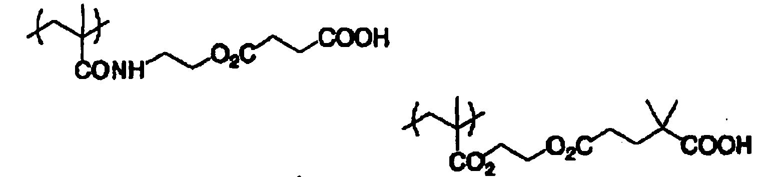

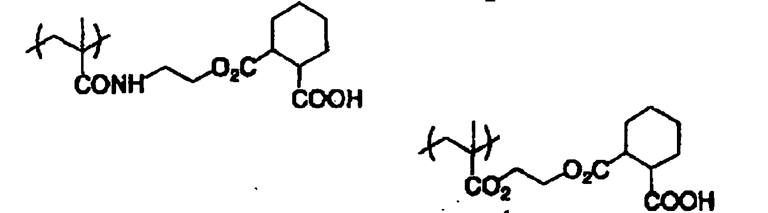

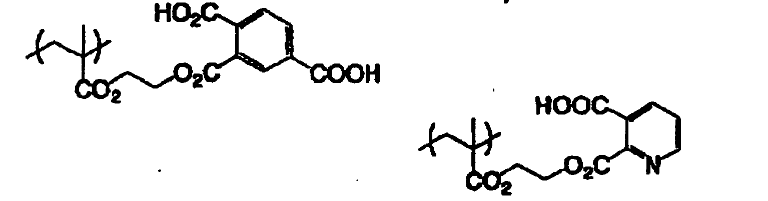

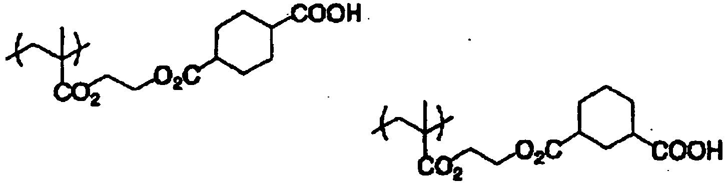

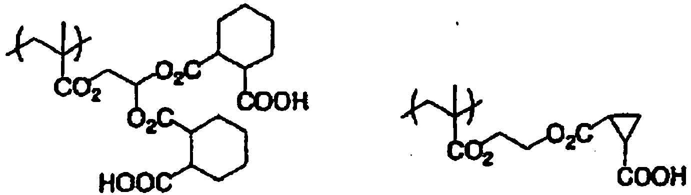

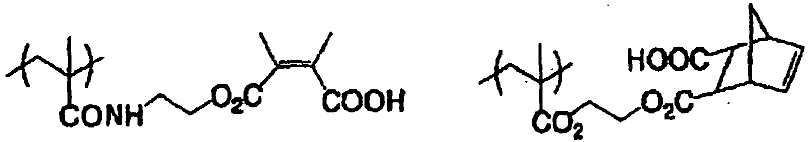

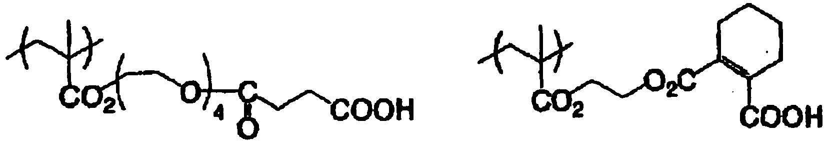

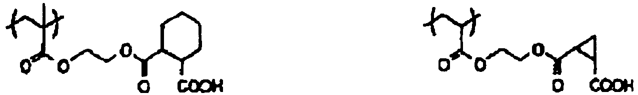

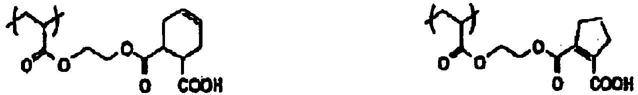

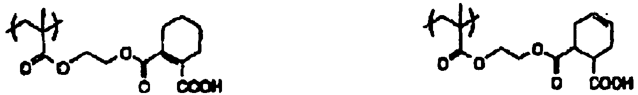

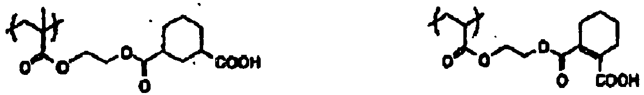

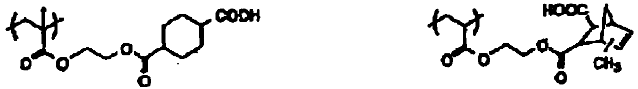

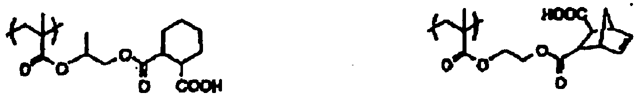

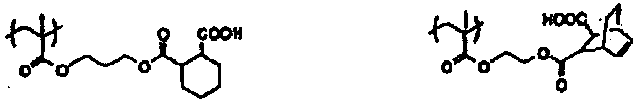

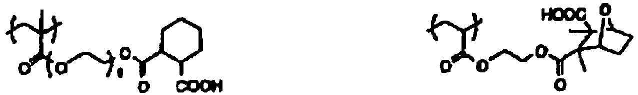

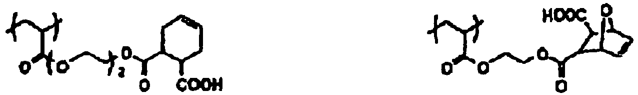

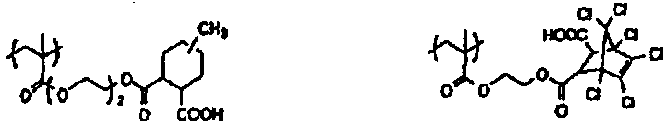

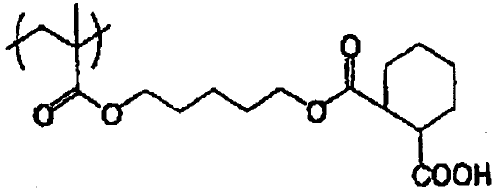

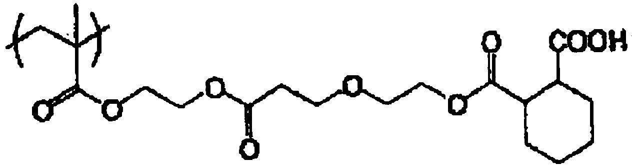

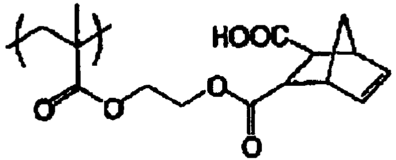

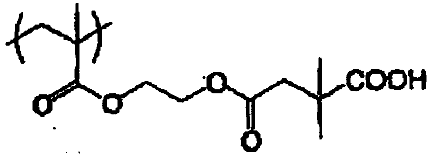

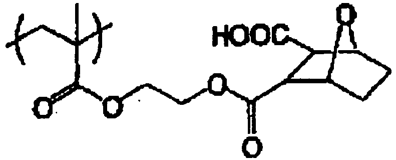

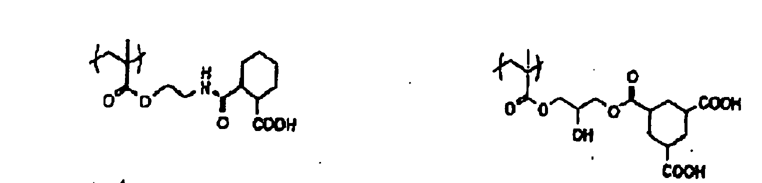

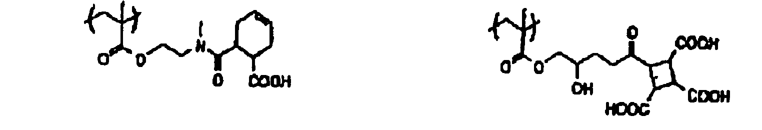

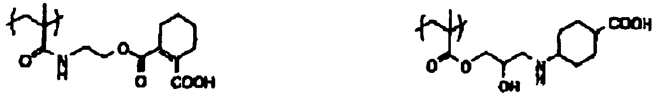

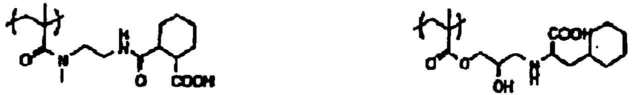

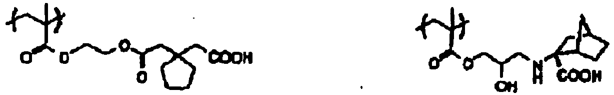

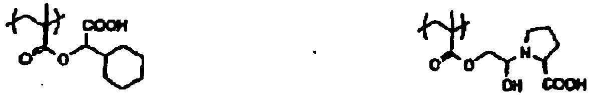

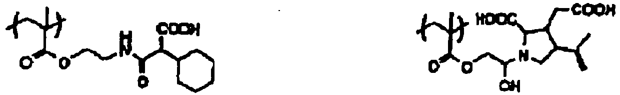

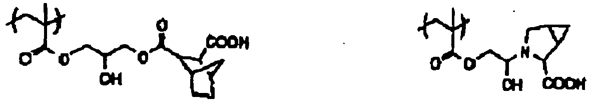

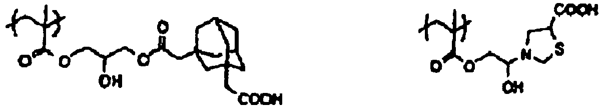

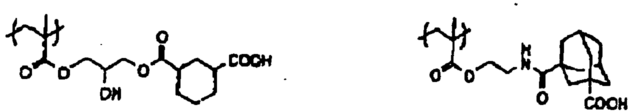

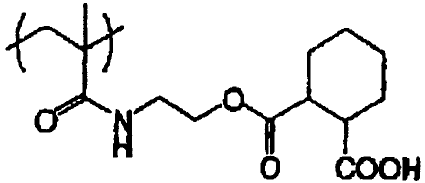

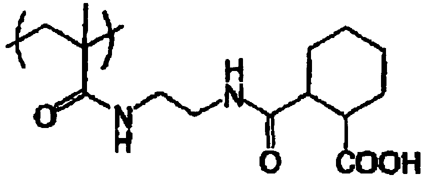

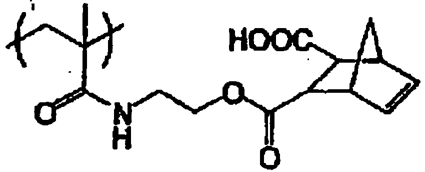

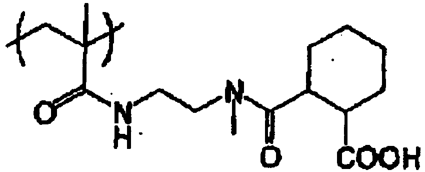

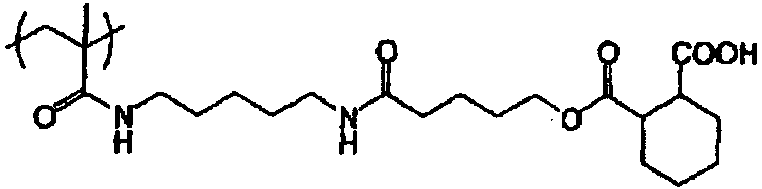

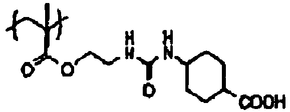

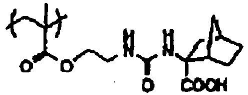

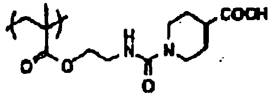

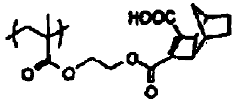

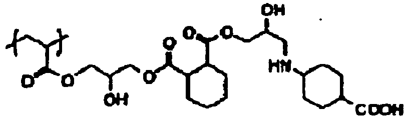

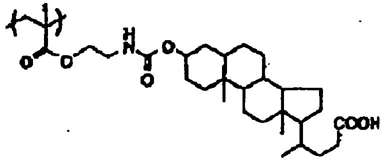

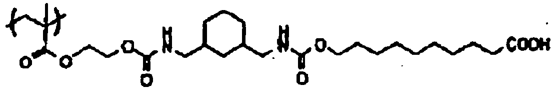

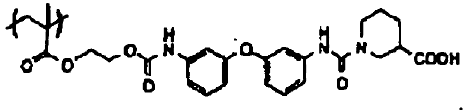

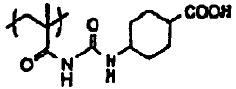

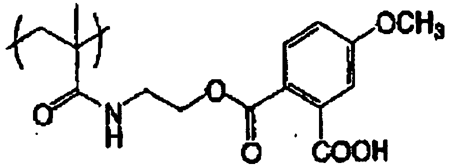

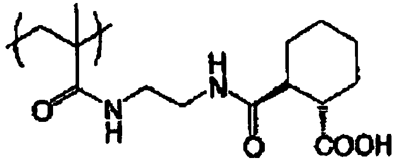

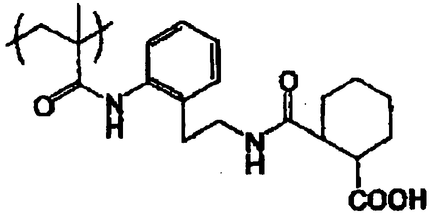

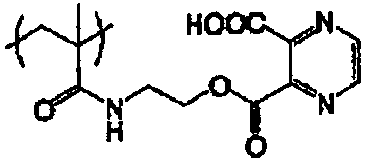

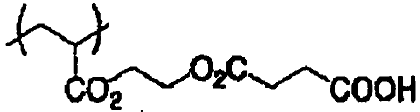

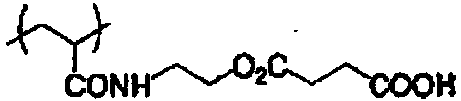

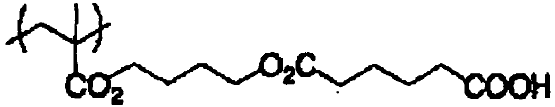

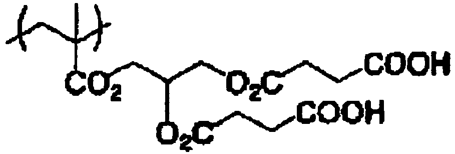

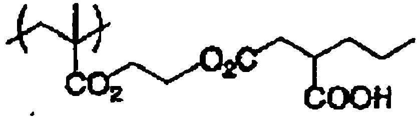

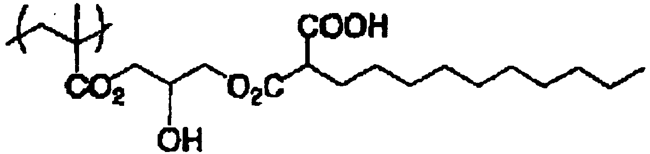

The specific (meth)acrylic resin according to the invention is preferably a copolymer comprising the repeating unit represented by formula (i), a repeating unit having a crosslinkable group (for example, the group represented by formula (1), (2) or (3) described above) in a side chain, and , if desired, a repeating unit of other copolymerization component, in combination. The repeating units represented by formula (i) may be incorporated individually or in combination of two or more thereof into the specific (meth)acrylic resin. Although the total content of the repeating unit represented by formula (i) can be appropriately determined in consideration of the structure thereof, design of the photosensitive layer, or the like, it is preferably from 1 to 99% by mole, more preferably from 5 to 40% by mole, and still more preferably from 5 to 20% by mole, based on the total molar amount of the resin component.

Other examples of the polymer having an ethylenically unsaturated bond which is a crosslinkable group in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include -(CH₂)ₙCR¹=CR²R³, -(CH₂O)ₙCH₂CR¹=CR²R³, -(CH₂CH₂O)ₙCH₂CR¹=R²R³, -(CH²)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl group having from 1 to 20 carbon atoms, an aryl group, an alkoxy group or an aryloxy group, or R¹ and R² or R¹ and R³ may be combined with each other to form a ring. n represents an integer of 1 to 10. X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amido residue include -CH₂CH=CH₂, -CH₂CH₂-Y (wherein Y represents a cyclohexene residue) and -CH₂CH₂-OCO-CH=CH₂.

The binder polymer having a crosslinkable property is hardened, for example, by adding a free radical (a polymerization initiating radical or a growing radical of a polymerizable compound in the course of polymerization) to the crosslinkable functional group of the polymer and undergoing addition polymerization between the polymers directly or through a polymerization chain of the polymerizable compound to form crosslinkage between the polymer molecules. Alternately, it is hardened by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

A content of the crosslinkable group in the binder polymer (content of the radical polymerizable unsaturated double bond determined by iodine titration) is preferably from 0.1 to 10.0 mmol, more preferably from 1.0 to 7.0 mmol and most preferably from 2.0 to 5.5 mmol, based on 1 g of the binder polymer. In the above-described range, both preferable sensitivity and good preservation stability can be obtained.

As the other copolymerization component described above, a conventionally known radical polymerizable monomer may be used without any limitation. Specific examples thereof include monomers described in Kobunshi Data Handbook-Kisohen- (Polymer Data Handbook, Fundamental Edition), compiled by Kobunshi Gakkai, Baifukan Co., Ltd. (1986). Such copolymerization components may be used independently or in combination of two or more thereof

Although an amount of the polymer binder having a crosslinkable group added in the photosensitive layer can be appropriately determined, it is ordinarily in a range from 10 to 90% by weight, preferably from 20 to 80% by weight, and more preferably from 30 to 70% by weight, based on the total weight of the nonvolatile component in the photosensitive layer.

Also, a ratio of the photopolymerizable ethylenically unsaturated bond-containing compound to the polymer binder having a crosslinkable group is preferably in a range from 1/9 to 9/1, more preferably from 2/8 to 8/2, and still more preferably from 3/7 to 7/3, in terms of weight.

As the polymer binder, one or more of other resins may be used together with the polymer binder having a crosslinkable group. As the other resin used together, a conventionally known alkali-soluble or alkali-swellable binder can be used without any limitation. Specifically, an acryl main chain binder or a urethane binder conventionally used in the art is preferably used.

The other resin used together is ordinarily employed in an amount of 50% by weight or less, preferably 30% by weight or less, based on the weight of the polymer binder having a crosslinkable group.

A molecular weight of the polymer binder used in the invention is appropriately determined in consideration of the image-forming property and printing durability. A weight average molecular weight thereof is preferably in a range from 2,000 to 1,000,000, more preferably from 5,000 to 500,000, and still more preferably from 10,000 to 200,000,

### [Polymerization initiation system]

As the polymerization initiation system incorporated into the photosensitive layer according to the invention, any of a photopolymerization initiation system (photon mode initiation system) and a heat mode initiation system can be used.

### (Photopolymerization initiation system)

The photopolymerization initiation system (photopolymerization initiator) incorporated into the photosensitive layer of the photosensitive lithographic printing plate according to the invention can be appropriately selected to use from various photoinitiators known in patents and literatures and a combination system (photo-initiation system) of two or more photoinitiators depending on a wavelength of a light source used. Specific examples thereof are illustrated below, but the invention should not be construed as being limited thereto.

Various photo-initiation systems have also been proposed for using visible light of 400 nm or more, Ar laser, second harmonic of semiconductor laser or SHG-YAG laser as the light source. For instance, there are illustrated a certain kind of photo-reductive dyes (e.g., Rose Bengal, Eosin or Erythrosine) described in U.S. Patent 2,850,445 and a system comprising a combination of a dye and an initiator, for example, a composite initiation system of a dye and an amine (described in JP-B-44-20189), a combination system of a hexaarylbiimidazole, a radical generator and a dye (described in JP-B-45-37377), a system of a hexaarylbiimidazole and a p-dialkylaminobenzylidene ketone (described in JP-B-47-2528 and JP-A-54-155292), a system of a cyclic cis-α-dicarbonyl compound and a dye (described in JP-A-48-84183), a system of a cyclic triazine and a merocyanine dye (described in JP-A-54-151024), a system of a 3-ketocoumarin and an activator (described in JP-A-52-112681 and JP-A-58-15503), a system of a biimidazole, a styrene derivative and a thiol (described in JP-A-59-140203), a system of an organic peroxide and a dye (described in JP-A-59-1504, JP-A-59-140203, JP-A-59-189340, JP-A-62-174203, JP-B-62-1641 and U.S. Patent 4,766,055), a system of a dye and an active halogen compound (described in JP-A-63-258903 and JP-A-2-63054), a system of a dye and a borate compound (described in JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing dye and a radical generator (described in JP-A-2-179643 and JP-A-2-244050), a system of a titanocene and a 3-ketocoumarin dye (described in JP-A-63-221110), a system wherein a titanocene is combined with a xanthene dye and, further, an amino group- or urethane group-containing addition-polymerizable ethylenically unsaturated compound (described in JP-A-4-221958 and JP-A-4-219756), a system of a titanocene and a specific merocyanine dye (described in JP-A-6-295061), and a system of a titanocene and a benzopyran ring-containing dye (described in JP-A-8-334897).

Recently, a laser (violet laser) emitting light having a wavelength of 400 to 410 nm has been developed, and in response thereto a photo-initiation system showing a high sensitivity to light having a wavelength of 450 nm or less has been developed. Such photo-initiation system can also be employed. Examples thereof include a cation dye/borate system (described in JP-A-11-84647), a merocyanine dye/titanocene system (described in JP-A-2000-147763), and a carbazole type dye/titanocene system (described in JP-A-2001-42524). In the invention, a titanocene compound and a hexaarylbiimidazole compound are particularly preferred.

As the titanocene compound, various compounds can be used. For example, the compound may be appropriately selected to use from various titanocene compounds described in JP-A-59-152396 and JP-A 61-151197. Specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicydopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-tetrafluorophen-1-yl, dimethylcyclopentadienyl-Ti-bis-2,6-difluorophen-1-yl and dicyclopentadienyl-Ti-bis-2,6-difluoro-3-(pyr-1-yl)phen-1-yl.

As the hexaarylbiimidazole compound, various compounds can be used. Examples of the hexaarylbiimidazole compound include lophine dimers described in JP-B-45-37377 and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4', 5, 5'-tetraphenylbiimidazole, 2,2'-bis(o-methylphenyl)-4,4',5,5' -tetraphenylbiimidazole, 2,2'-bis(o-trifluoromethylphenyl)-4,4',5,5'-tetraphenylbiimidazole, 2,2'-bis(o,m-dichlorophenyl)-4,4',5,5'-tetraphenylbiimidazole and 2,2'-bis(o-chlorophenyl)-4,4',5,5'-tetra(p-bromophenyl)biimidazole.

Among them, 2,2'-bis(o-chlorophenyl)-4,4',5,5'-tetraphenylbiimidazole, 2,2'-bis(o,m-dichlorophenyl)-4,4',5,5'-tetraphenylbiimidazole and 2,2'-bis(o-chlorophenyl)-4,4',5,5'-tetra(p-bromophenyl)bisimidazole are preferable.

Further, in the photopolymerization initiation system, a known compound which is referred to as a chain transfer agent or co-sensitizer capable of more enhancing photo-initiation ability by using in combination with the photopolymerization initiator can be employed, if desired. Examples of such compound include a hydrogen-donating compound, for example, a thiol compound (e.g., 2-mercaptobenzothiazole, 2-mercaptobenzimidazole or 2-mercaptobenzoxazole) or an amine compound (e.g., N-phenyglycine or N,N-dialkylamino aromatic alkyl ester).

An amount of the photopolymerization initiator (photopolymerization initiation system) used is ordinarily in a range from 0.05 to 100 parts by weight, preferably from 0.1 to 70 parts by weight, and still more preferably from 0.2 to 50 parts by weight, based on 100 parts by weight of the ethylenically unsaturated bond-containing compound.

### (Heat mode initiation system)

To the photosensitive lithographic printing plate according to the invention can also applied a heat mode polymerization system. In the heat mode polymerization system, a combination of an infrared absorbing agent with a polymerization initiator is used. The hydrogen-donating compound, chain transfer agent or the like may be used by appropriately selecting from those described in the photopolymerization initiation system, if desired.

### (1) Infrared absorbing agent

The infrared absorbing agent has a function of converting an infrared ray adsorbed to heat. By the heat thus-generated, a polymerization initiator (radical generator) described hereinafter is thermally decomposed to generate a radical. The infrared absorbing agent for use in the invention preferably includes a dye and pigment each having an absorption maximum in a wavelength range of 760 to 1,200 nm.

As the dye, commercially available dyes and known dyes described in literatures, for example, Senryo Binran (Dye Handbook) compiled by The Society of Synthetic Organic Chemistry, Japan (1970) can be utilized. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Preferred examples of the dye include cyanine dyes described, for example, in JP-A-58-125246, JP-A-59-84356 and JP-A-60-78787; methine dyes described, for example, in JP-A-58-173696, JP-A-58-181690 and JP-A-58-194595; naphthoquinone dyes described, for example, in JP-A-58-112793, JP-A-58-224793, JP-A-59-48187, JP-A-59-73996, JP-A-60-52940 and JP-A-60-63744; squarylium dyes described, for example, in JP-A-58-112792; and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A 59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium comounds described in JP-B-5-13514 and JP-B-5-19702 are also preferably used. Other preferred examples of the dye include near infrared absorbing dyes represented by formulae (I) and (II) described in U.S. Patent 4,756,993.

Other preferred examples of the infrared absorbing dye according to the invention include specific indolenine cyanine dyes described in JP-A-2002-278057 as illustrated below.

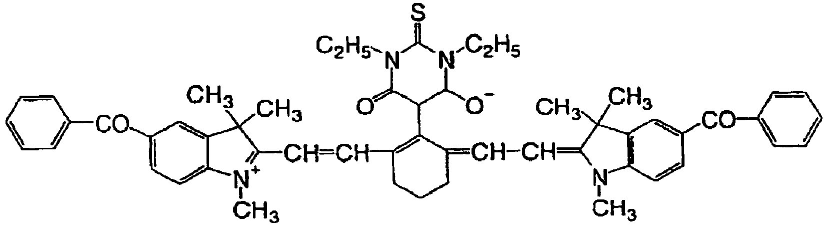

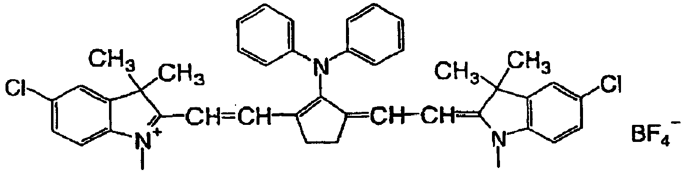

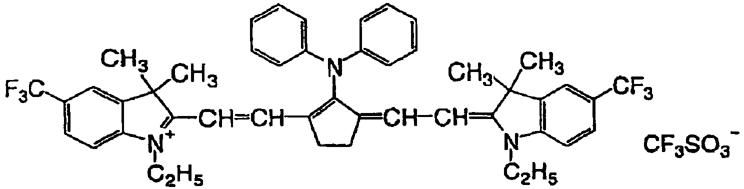

In particular, of the dyes, cyanine dyes, squarylium dyes, pyrylium dyes, nickel thiolate complexes and indolenine cyanine dyes are preferred. Cyanine dyes and indolenine cyanine dyes are more preferred. As a particularly preferred example of the dye, a cyanine dye represented by formula (a) shown below is exemplified.
Formula (a):

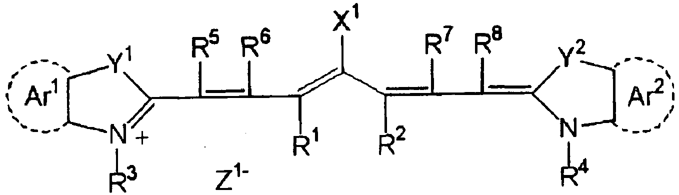

In formula (a), X¹ represents a hydrogen atom, a halogen atom, -NPh₂, X²-L¹ or a group shown below.

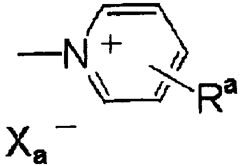

In the above, X² represents an oxygen atom, a nitrogen atom or a sulfur atom, and L¹ represents a hydrocarbon group having from 1 to 12 carbon atoms, an aromatic cyclic group containing a hetero atom or a hydrocarbon group having from 1 to 12 carbon atoms and containing a hetero atom. The term "hetero atom" as used herein means a nitrogen atom, a sulfur atom, an oxygen atom, a halogen atom or a selenium atom. Xa⁻ has the same meaning as Z¹⁻ defined hereinafter, and R^{a} represents a hydrogen atom or a substituent selected from an alkyl group, an aryl group, a substituted or unsubstituted amino group and a halogen atom.

In formula (a), R¹ and R² each independently represents a hydrocarbon group having from 1 to 12 carbon atoms. In view of preservation stability of a coating solution for photosensitive layer, it is preferred that R¹ and R² each represents a hydrocarbon group having two or more carbon atoms, and particularly preferably, R¹ and R² are combined with each other to form a 5-membered or 6-membered ring.

In formula (a), Ar¹ and Ar², which may be the same or different, each represents an aromatic hydrocarbon group which may have a substituent. Preferred examples of the aromatic hydrocarbon group include a benzene ring and a naphthalene ring. Also, preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent. Preferred examples of the substituent include an alkoxy group having 12 or less carbon atoms, a carboxy group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Z¹⁻ represents a counter anion. However, Z¹⁻ is not necessary when the cyanine dye represented by formula (a) has an anionic substituent in the structure thereof so that neutralization of charge is not needed. Preferred examples of the counter anion for Z¹⁻ include a halogen ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of the preservation stability of a coating solution for photosensitive layer.

Specific examples of the cyanine dye represented by formula (a) which can be preferably used in the invention include those described in paragraphs from [0017] to [0019] of JP-A-2001-133969.

Further, other particularly preferable examples of the dye include the specific indolenine cyanine dyes described in JP-A-2002-278057 described above.

Examples of the pigment used in the invention include commercially available pigments and pigments described in Colour Index (C.I.), Saishin Ganryo Binran (Handbook of Newest Pigments) compiled by Pigment Technology Society of Japan (1977), Saishin Ganryo Oyou Gijutsu (Newest Application Technologies of Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of the pigment used include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after conducting the surface treatment. For the surface treatment, a method of coating a resin or wax on the pigment surface, a method of attaching a surfactant to the pigment surface and a method of bonding a reactive substance (for example, a silane coupling agent, an epoxy compound or a polyisocyanate) to the pigment surface are exemplified. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application Technologies of Pigments), CMC Publishing Co., Ltd. (1986).

A particle size of the pigment is preferably in a range from 0.01 to 10 µm, more preferably in a range from 0.05 to 1 µm, particularly preferably in a range from 0.1 to 1 µm. The particle size of the pigment less than 0.01 µm is not preferable in view of stability of the pigment dispersion in a coating solution for photosensitive layer. The particle size of the pigment exceeding 10 µm is also not preferable in view of uniformity of the photosensitive layer.

As a method for dispersing the pigment, a known dispersion technique for use in the production of ink or toner can be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing methods are described in detail in Saishin Ganryo Oyo Gijutsu (Newest Application Technologies of Pigments), CMC Publishing Co., Ltd. (1986).

The infrared absorbing agent may be added to the photosensitive layer or may be added to a different layer separately provided. With respect to an amount of the infrared absorbing agent added, in the case of preparing a negative-working photosensitive lithographic printing plate, the amount is so controlled that absorbance of the photosensitive layer at the maximum absorption wavelength in the wavelength region of 760 to 1,200 nm measured by a reflection measurement method is ordinarily in a range from 0.5 to 1.2, preferably in a range from 0.6 to 1.15. When the absorbance is out of the range, there is the threat of degrading strength of the image area, resulting in decrease of a number of prints at printing. Although the reason for this is not quite clear, when the absorbance is less than 0.5, it is believed that the infrared ray irradiated can not be sufficiently absorbed and as a result, the radical polymerization does not proceed enough in the entire photosensitive layer. On the other hand, when the absorbance is more than 1.2, it is believed that the uppermost surface of the photosensitive layer only absorbs the infrared ray and the infrared ray does not reach to the portion near to the support and as a result, the radical polymerization does not occur in the portion near to the support, resulting in inadequate adhesion between the photosensitive layer and the support.

The absorbance of the photosensitive layer can be controlled according to the amount of the infrared absorbing agent added to the photosensitive layer and the thickness of the photosensitive layer. The measurement of the absorbance can be carried out in a conventional manner. The method for measurement includes, for example, a method of forming a photosensitive layer having a thickness appropriately determined in the range of coating amount after drying required for the photosensitive lithographic printing plate on a reflective support, for example, an aluminum plate, and measuring reflection density of the photosensitive layer by an optical densitometer or a spectrophotometer according to a reflection method using an integrating sphere.

### (2) Polymerization initiator

In the heat mode system, a polymerization initiator which generates a radical by heat occurred from the infrared absorbing agent used together upon irradiation of an infrared laser is employed. Although the polymerization initiator for the heat mode can be selected from the polymerization initiators described in the photopolymerization initiation system, it is preferably an onium salt. As a particularly preferable polymerization initiator for the heat mode, a sulfonium salt polymerization initiator is exemplified. According to the invention, the combination of the infrared absorbing agent with the onium salt polymerization initiator enables highly sensitive heat mode recording.

Examples of the sulfonium salt polymerization initiator preferably used in the invention include an onium salt represented by formula (I) shown below.
Formula (I):

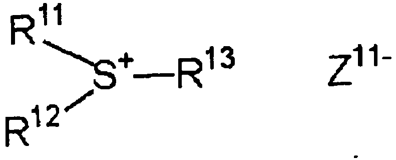

In formula (I), R¹¹, R¹² and R¹³, which may be the same or different, each represents a hydrocarbon group having 20 or less carbon atoms, which may have a substituent. Preferred examples of the substituent include a halogen atom, a nitro group, an alkyl group having 12 or less carbon atoms, an alkoxy group having 12 or less carbon atoms and an aryloxy group having 12 or less carbon atoms. Z¹¹⁻ represents a counter ion selected from a halogen ion, a perchlorate ion, a tetrafluoroborate ion, hexafluorophosphate ion, a carboxylate ion and a sulfonate ion, and is preferably a perchlorate ion, a hexafluorophosphate ion, a carboxylate ion or an arylsulfonate ion.

Specific examples of the onium salts ([OS-1] to [OS-10]) represented by formula (I) are set forth below, but the invention should not be construed as being limited thereto.

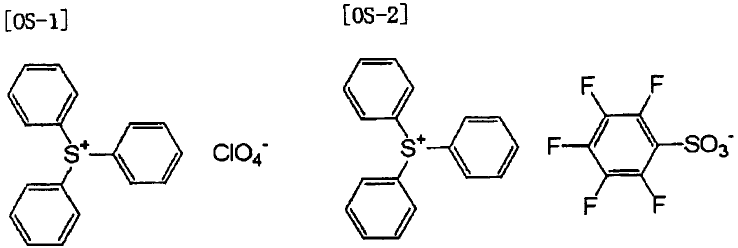

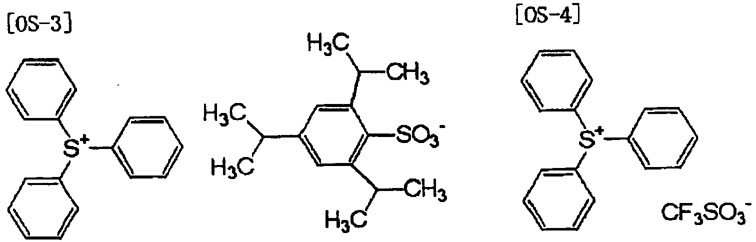

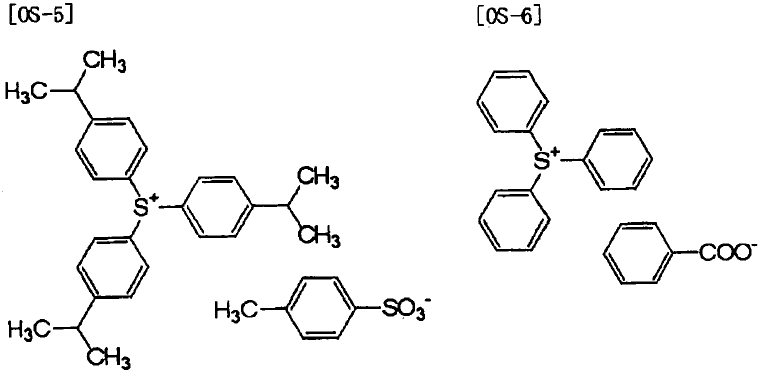

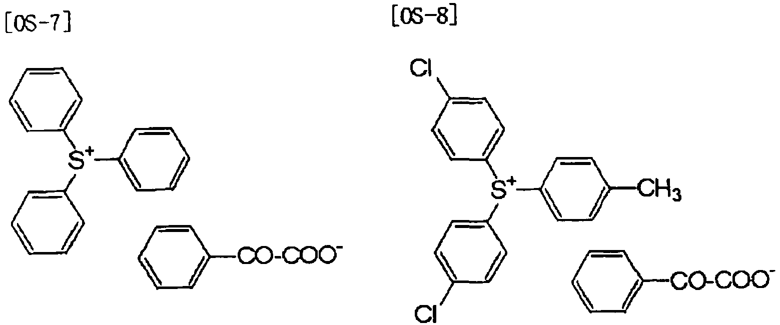

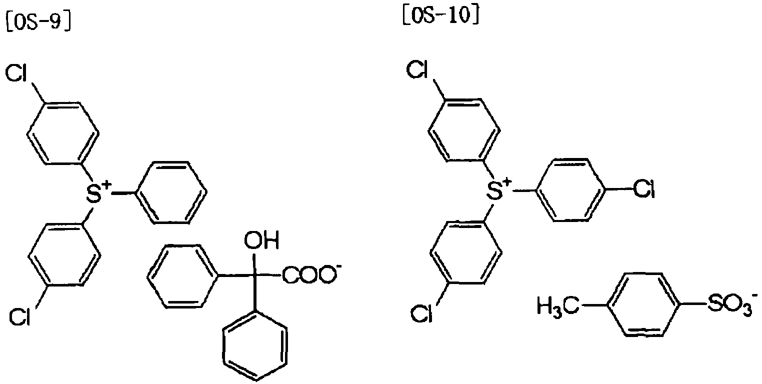

In addition to the above, specific aromatic sulfonium salts described in JP-A-2002-148790, JP-A-2002-148790, JP-A-2002-350207 and JP-A-2002-6482 are also preferably used.

According to the invention, onium salts other than the above-described sulfonium salt polymerization initiator are also preferably used.

Examples of such an onium salt include an iodonium salt and a diazonium salt. More specifically, onium salts represented by formulae (II) and (III) shown below are exemplified.

Formula (II): Ar²¹-I⁺-Ar²² Z²¹⁻

Formula (III): Ar³¹-N⁺≡N Z³¹⁻

In formula (II), Ar²¹ and Ar²² each independently represents an aryl group having 20 or less carbon atoms, which may have a substituent. When the aryl group has a substituent, preferred examples of the substituent include a halogen atom, a nitro group, an alkyl group having 12 or less carbon atoms, an alkoxy group having 12 or less carbon atoms and an aryloxy group having 12 or less carbon atoms. Z²¹⁻ represents a counter ion having the same meaning as defined for Z¹¹⁻.

In formula (III), Ar³¹ represents an aryl group having 20 or less carbon atoms, which may have a substituent. Preferred examples of the substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms and a diarylamino group having 12 or less carbon atoms. Z³¹⁻ represents a counter ion having the same meaning as defined for Z¹¹⁻.

Specific examples of the onium salts ([OI-1] to [OI-10] represented by formula (II) and the onium salts ([ON-1] to [ON-5]) represented by formula (III), which are preferably used in the invention, are set forth below, but the invention should not be construed as being limited thereto.

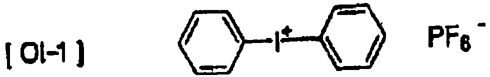

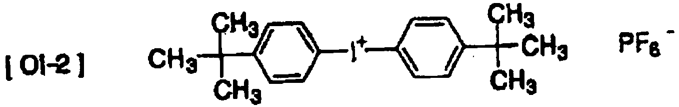

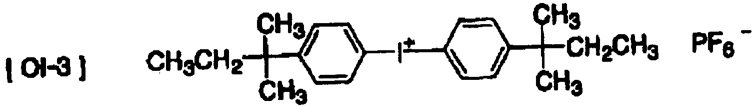

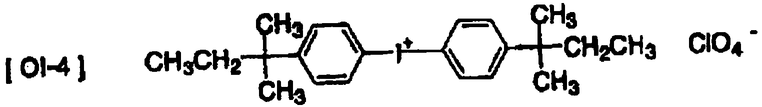

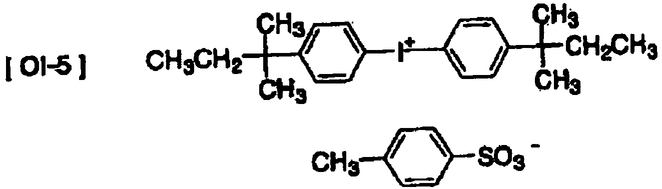

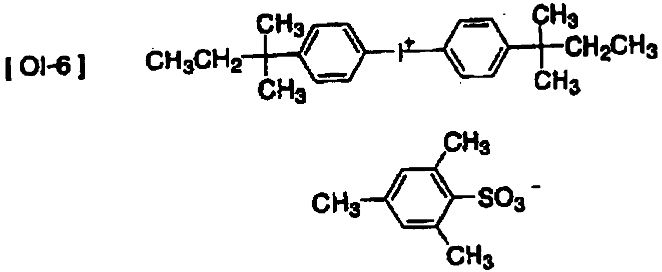

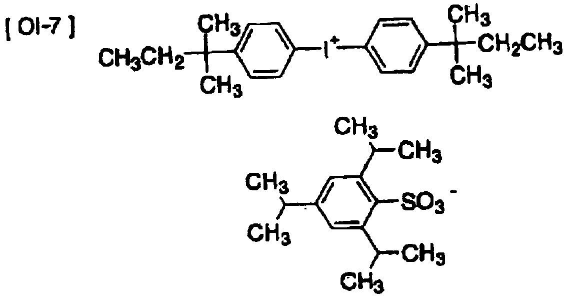

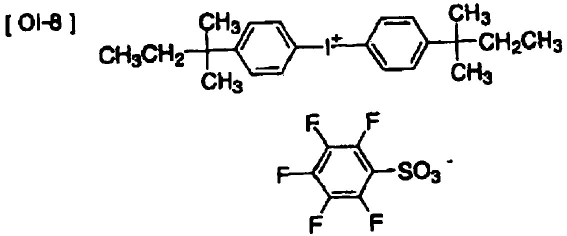

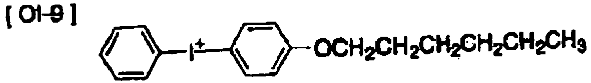

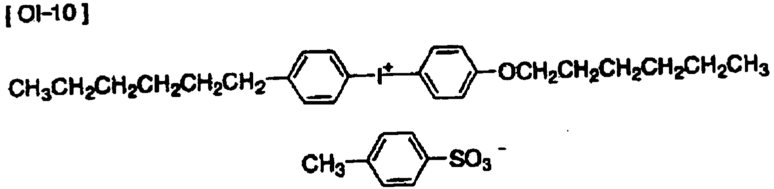

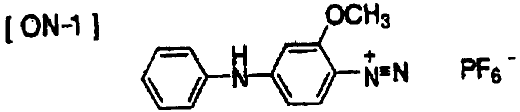

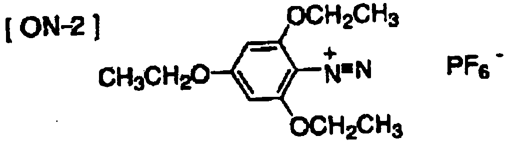

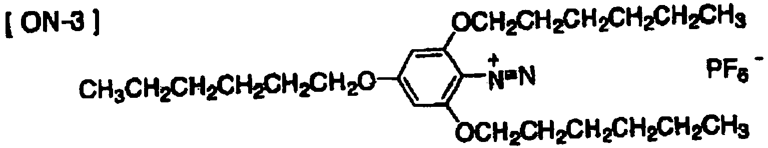

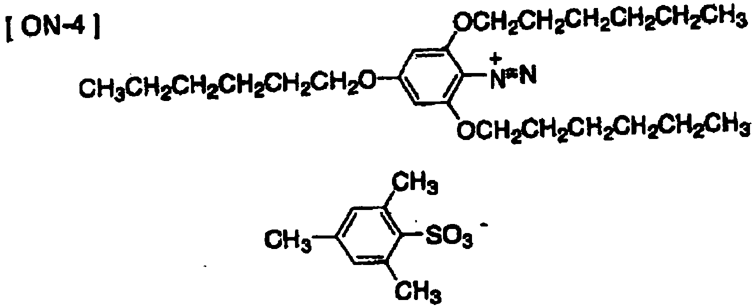

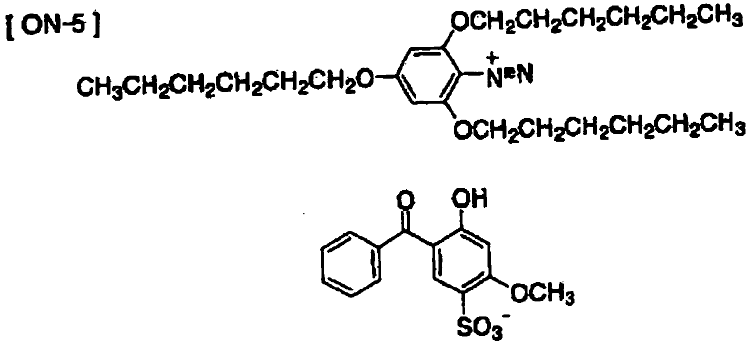

Specific examples of the onium salt which is preferably used as the polymerization initiator in the invention include those described in JP-A-2001-133969.

The polymerization initiator (radical generator) for use in the invention has preferably a maximum absorption wavelength of 400 nm or shorter, more preferably 360 nm or shorter. By adjusting the absorption wavelength in an ultraviolet region as above, handling of the photosensitive lithographic printing plate can be conducted under white light.

The total content of the polymerization initiator in the photosensitive layer is ordinarily from 0.1 to 50% by weight, preferably from 0.5 to 30% by weight, and particularly preferably from 1 to 20% by weight, based on the total solid content of the photosensitive layer.

### [Thermal polymerization inhibitor]

It is desired to add a small amount of a thermal polymerization inhibitor in addition to the fundamental components described above to the photosensitive layer according to the invention in order to prevent undesirable thermal polymerization of the polymerizable ethylenically unsaturated bond-containing compound during the production or preservation of the photosensitive layer. Suitable examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxylamine cerium (III) salt and N-nitrosophenylhydroxylamine aluminum salt.

An amount of the thermal polymerization inhibitor added is preferably from about 0. 01 to about 5% by weight based on the total solid content constituting the photosensitive layer.

Further, a higher fatty acid or a derivative thereof, for example, behenic acid or behenic amide may be added to the photosensitive layer and localized on the surface of the photosensitive layer during a drying process after coating in order to prevent polymerization inhibition due to oxygen, if desired. An amount of the higher fatty acid or derivative thereof added is preferably from about 0. 5 to about 10% by weight based on the total solid content constituting the photosensitive layer.

### [Other additive]

Moreover, a coloring agent may be added for the purpose of coloring the photosensitive layer. Examples of the coloring agent include a pigment, for example, a phthalocyanine pigment (e.g., C. I. Pigment Blue 15:3, 15:4 or 15:6), an azo pigment, carbon black or titanium oxide, and a dye, for example, Ethyl Violet, Crystal Violet, an azo dye, an anthraquinone dye or a cyanine dye. An amount of the coloring agent added is preferably from about 0. 5 to about 20% by weight based on the total solid content of the photosensitive layer. In addition, an additive, for example, an inorganic filler or a plasticizer, e.g., dioctyl phthalate, dimethyl phthalate or tricresyl phosphate may be added in order to improve physical properties of the cured film. An amount of such an additive added is preferably not more than 10% by weight based on the total solid content of the photosensitive layer.

### [Coating solution]

In the coating of the photosensitive layer, each component described above is dissolved in a solvent to prepare a coating solution. Examples of the solvent used include an organic solvent, for example, acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate or ethyl lactate. The solvents may be used individually or as a mixture thereof

The concentration of solid content in the coating solution is ordinarily from 1 to 50% by weight.

Further, in order to improve surface quality of coating, a surfactant may be added to the coating solution.

The coverage of the photosensitive layer is ordinarily from about 0.1 to about 10 g/m², preferably from 0.3 to 5 g/m², and more preferably from 0.5 to 3 g/m², in terms of weight after drying.

### <Support>

The photosensitive layer is provided on a support having a hydrophilic surface according to the invention. As for the hydrophilic support, conventionally known hydrophilic supports used for lithographic printing plates can be used without any limitation. The support used is preferably a dimensionally stable plate-like material, for example, paper, paper laminated with plastic (e.g., polyethylene, polypropylene or polystyrene), a metal plate (e.g., aluminum, zinc or copper plate), a plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated or vapor-deposited thereon the above-described metal. If desired, the surface of the support may be subjected to an appropriate known physical or chemical treatment for the purpose of imparting hydrophilicity, improving the strength or the like.

Preferred examples of the support include paper, a polyester film and an aluminum plate. Among them, the aluminum plate is particularly preferred, because it has good dimensional stability, is relatively inexpensive and can provide a surface having excellent hydrophilicity and strength by a surface treatment as needed. Also, a composite sheet comprising a polyethylene terephthalate film having bonded thereon an aluminum sheet described in JP-B-48-18327 is preferred.

The aluminum substrate is a dimensionally stable metal plate comprising aluminum as a main component, and is selected from a pure aluminum plate, an alloy plate comprising aluminum as a main component and containing trace of foreign elements and a plastic film or paper laminated with or having vapor-deposited thereon aluminum (or alloy thereof).

In the description below, the substrate comprising aluminum or aluminum alloy described above is collectively referred to as an aluminum substrate. Examples of the foreign element contained in the aluminum alloy include silicon, iron, manganese, copper, magnesium, chromium, zinc, bismuth, nickel and titanium. The content of foreign element in the alloy is at most 10% by weight. Although a pure aluminum palate is preferable in the invention, an aluminum plate containing trace of foreign elements may be used, because perfectly pure aluminum is difficult to produce in view of the refining technique.

The composition of the aluminum plate for use in the invention is not limited and aluminum plates comprising conventionally known and used materials, for example, JIS A 1050, JIS A 1100, JIS A 3103 or JIS A 3005 can be appropriately used. The thickness of the aluminum substrate for use in the invention is approximately from 0.1 to 0.6 mm, preferably from 0.15 to 0.4 mm, and particularly preferably from 0.2 to 0.3 mm. The thickness can be appropriately changed depending upon the size of a printing machine, the size of a printing plate and the demands of users. The aluminum substrate may or may not be subjected to a surface treatment for the substrate described hereinafter.

The aluminum substrate is ordinarily subjected to a surface roughening treatment. The surface roughening method includes a method of mechanically roughening the surface, a method of chemical etching and a method of electrolytic graining, as described in JP-A-56-28893. Further, there may be employed an electrochemically surface roughening method of electrochemically roughening the surface in an electrolytic solution of hydrochloric acid or nitric acid and a mechanically surface roughening method, for example, a wire brush graining method of scratching the aluminum surface with a metal wire, a ball graining method of graining the aluminum surface with graining balls and an abrasive and a brush graining method of roughening the surface with a nylon brush and an abrasive. The surface roughening methods may be employed individually or in combination thereof Of the methods, the electrochemical method of chemically roughening the surface in an electrolytic solution of hydrochloric acid or nitric acid is an advantageous surface roughening method, and an appropriate anodic time electricity is in the range of from 50 to 400 C/dm². More specifically, it is preferred to conduct alternating current and/or direct current electrolysis in an electrolytic solution containing from 0.1 to 50% by weight hydrochloric acid or nitric acid under the conditions from 20 to 80°C in temperature, 1 second to 30 minutes in time and 100 to 400 C/dm² in electric current density.

The thus surface-roughened aluminum substrate may be chemically etched with an acid or an alkali. The etching agent preferably used includes, for example, sodium hydroxide, sodium carbonate, sodium aluminate, sodium metasilicate, sodium phosphate, potassium hydroxide and lithium hydroxide. A preferred concentration is in the range of 1 to 50% by weight, and a preferred temperature is in the range of 20 to 100°C. Washing with an acid is conducted for removing stain (smut) remaining on the etched surface. Examples of the acid used include nitric acid, sulfuric acid, phosphoric acid, chromic acid, hydrofluoric acid and borohydrofluoric acid. As a specific method for desmutting after the electrochemically surface roughening treatment, there are illustrated a method of contacting the aluminum substrate with sulfuric acid from 50 to 90°C in temperature and from 15 to 65% by weight in concentration described in JP-A-53-12739 and a method of etching the substrate with an alkali described in JP-B-48-28123. The method and conditions are not particularly limited as long as the treated surface has a center-line average roughness, Ra, of 0.2 to 0.5 µm.

The thus surface-roughened aluminum substrate is then subjected to an anodizing treatment to form thereon an oxide film. In the anodizing treatment, sulfuric acid, phosphoric acid, oxalic acid and an aqueous solution of boric acid/sodium borate are used individually or in combination of two or more thereof as a major component of an electrolytic bath. In this occasion, ingredients at least ordinarily contained in an aluminum alloy plate, electrodes, city water, ground water and the like may of course be contained in the electrolytic solution. Further, a second or a third component may be added. Examples of the second and third components include a cation, for example, an ion of metal, e.g., Na, K, Mg, Li, Ca, Ti, Al, V, Cr, Mn, Fe, Co, Ni, Cu or Zn or ammonium ion and an anion, for example, nitrate ion, carbonate ion, chloride ion, phosphate ion, fluoride ion, sulfite ion, titanate ion, silicate ion and borate ion. The ion is allowed to be contained in a concentration of approximately from 0 to 10,000 ppm. Although conditions of the anodizing treatment are not particularly limited, the treatment is preferably conducted by direct current or alternating current electrolysis of from 30 to 500 g/liter in concentration, from 10 to 70°C in temperature and from 0.1 to 40 A/m² in electric current density. The thickness of the formed anodic oxide film is in the range of from 0.5 to 1.5 µm, preferably from 0.5 to 1.0 µm.

Further, it is also preferred to undercoat the thus-treated substrate with a water-soluble resin (for example, polyvinylphosphonic acid, a polymer or copolymer having a sulfonic acid group in the side chain thereof or polyacryic acid), a water-soluble metal salt (for example, zinc borate), a yellow dye or an amine salt. Still further, a sol-gel treated substrate to which a functional group capable of causing an addition reaction upon a radical is connected via a covalent bond as described in JP-A-7-159983 is preferably used.

Other preferred examples of the support include those obtained by providing a water-resistant hydrophilic layer as a surface layer on an appropriate support. Examples of the surface layer include a layer comprising an inorganic pigment and a binder described in U.S. Patent 3,055,295 and JP-A-56-13168, a hydrophilic swellable layer described in JP-A-9-80744, and a sol-gel film comprising titanium oxide, polyvinyl alcohol and a silicic acid described in JP-T-8-507727 (The term "JP-T" as used herein means a published Japanese translation of a PCT patent application). The hydrophilizing treatment is conducted not only for the purpose of rendering the surface of the support hydrophilic, but also for the purpose of preventing harmful reactions of the photosensitive layer provided thereon and improving adhesion to the photosensitive layer.

### <Intermediate layer>

In the photosensitive lithographic printing plate according to the invention, an intermediate layer may be provided for the purpose of improving adhesion between the photosensitive layer and the substrate and improving stain resistance. Specific examples of the intermediate layer include those described, for example, in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A 7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824 and JP-A-2001-209170.

### <Interleaf paper>

In the invention, an interleaf paper is used in order to prevent damage of the protective layer during preservation or transportation of the photosensitive lithographic printing plate.

In general, photosensitive lithographic printing plates are preserved, stored and conveyed in the form of a stack thereof with interleaf papers inserted therebetween in order to protect the photosensitive lithographic printing plates from mechanical shock during the preservation or reduce undesirable shock during the transportation. Various kinds of interleaf papers are known.

As a paper material for the interleaf paper, wood pulp, synthetic pulp (polyethylene fiber), natural fiber (for example, hemp), regenerated cellulose or the like can be used.

For the manufacture of interleaf paper, a raw material of low cost is often selected in order to suppress the raw material cost. For example, paper manufactured using 100% of wood pulp, paper manufactured using a mixture of wood pulp and synthetic pulp, or paper having a low density or high density polyethylene layer provided on the surface of the above-described paper is used as the interleaf paper. In particular, in the case of paper using neither the synthetic pulp nor the polyethylene layer, since the raw material cost is suppressed, the interleaf paper can be manufactured at low cost.

More specifically, interleaf paper is manufactured by beating bleached kraft pulp, diluting to have concentration of 4% to prepare a paper material, adding a sizing agent in an amount of 0.1% based on the weight of the base paper and a paper strengthening agent in an amount of 0.2% based on the weight of the base paper, further adding aluminum sulfate so as to have pH of 5.0 to prepare a paper material and making paper using the paper material. The grammage of the interleaf paper is ordinarily from 20 to 60 g/m², preferably from 25 to 50 g/m² (according to the measurement method defined in JIS P 8124). The thickness of the interleaf paper is ordinarily from 42 to 80 µm, preferably from 45 to 55 µm, and more preferably from 40 to 50 µm (according to the measurement method defined in JIS P 8118). With respect to chemical requirements, interleaf paper is preferable from which NH₃ gas is not detected according to a NH₃ gas detecting method wherein 20 g of a sample of the interleaf paper is finely cut, put into 100 g of pure water, hermetically heated at 110°C for 10 minutes and then measuring NH₃ gas by a gas-detecting tube of Kitagawa type (for 20 ppm), and with which white turbidity is not recognized according to a chloride detecting method wherein 3 g of a sample of the interleaf paper is put into 6 ml of pure water, two droplets of a 1% by weight aqueous silver nitrate solution are added thereto and the presence or absence of white turbidity due to the chloride. With respect to preferable specifications of the interleaf paper, the grammage is from 30 to 60 g/m², smoothness is from 10 to 100 seconds according to the Bekk smoothness measurement method defined in JIS 8119, water content is from 4 to 8% according to the moisture content measurement method defined in JIS 8127, and density is from 0.7 to 0.9 g/cm³.

According to the invention, these known interleaf papers can be appropriately selected to use.

### <Plate-making method>

Now, a plate-making method of the photosensitive lithographic printing plate according to the invention will be described in detail. The photosensitive lithographic printing plate is imagewise exposed and then developed with an aqueous alkali solution. The developer for use in the plate-making method according to the invention is described below.

### [Developer]

The developer for use in the plate-making method of the photosensitive lithographic printing plate according to the invention is not particularly restricted. However, for example, a solution containing an inorganic alkali salt and a surfactant and having a pH from 11.0 to 12.7 is preferably used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used individually or in combination of two or more thereof

In the case of using the silicate, developing property can be easily adjusted by selecting a mixing ratio of silicon oxide (SiO₂) to alkali oxide (M₂O (wherein M represents an alkali metal or an ammonium group)), which are the components of the silicate, and the concentration thereof Of the aqueous alkali solutions, an aqueous alkali solution having the mixing ratio of silicon oxide (SiO₂) to alkali oxide (M₂O) (SiO₂/M₂O in molar ratio) of from 0.5 to 3.0 is preferred, and that of from 1.0 to 2.0 is more preferred. The amount of the SiO₂/M₂O added is preferably from 1 to 10% by weight, more preferably from 3 to 8% by weight, most preferably from 4 to 7% by weight, based on the weight of the aqueous alkali solution. When the concentration is in the above-described range, there arise no reduction in the developing property and processing ability, no formation of precipitates and crystals, and no gelation at neutralization of waste liquor of the developer, thereby causing no troubles in treatment of the waste liquor.

Also, an organic alkali agent may be supplementarily used for the purposes of delicate adjustment of alkali concentration and of assisting dissolution of the photosensitive layer. Examples of the organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used individually or in combination of two or more thereof

The surfactant is appropriately used. Examples thereof include nonionic surfactants, for example, a nonionic surfactant having a polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glycerol monooleate); anionic surfactants, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, compounds having the structure represented by formula (IV) shown below are preferably used.

R₄₀-O-(R₄₁-O)ₚH (IV)

In the formula, R₄₀ represents an alkyl group having from 3 to 15 carbon atoms, an aromatic hydrocarbon group having from 6 to 15 carbon atoms or a heteroaromatic ring group having from 4 to 15 carbon atoms. Each of these groups may have a substituent, and examples of the substituent include an alkylene group having from 1 to 20 carbon atoms, a halogen atom, e.g., Br, Cl or I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms which may have a substituent. Examples of the substituent include an alkyl group having from 1 to 20 carbon atoms and an aromatic hydrocarbon group having from 6 to 15 carbon atoms, p represents an integer of 1 to 100.

In the definition of the formula (IV), specific examples of the "aromatic hydrocarbon group" include a phenyl group, a tolyl group, a naphthyl group, an anthryl group, a biphenyl group and a phenanthryl group, and specific examples of the "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of(R₄₁-O)ₚ in the formula (IV) may comprise two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used individually or in combination thereof. The surfactant is effectively added in an amount from 1 to 30% by weight, preferably from 2 to 20% by weight, to the developer. When the amount of surfactant added is too small, the developing property may be deteriorated. On the other hand, when the amount is too large, development damage becomes increases and the printing durability of a printing plate may decrease.

Examples of the nonionic surfactant having polyoxyalkylene ether group represented by the formula (IV) include a polyoxyethylene alkyl ether, e.g., polyoxyethylene lauryl ether, polyoxyethylene cetyl ether or polyoxyethylene stearyl ether; a polyoxyethylene aryl ether, e.g., polyoxyethylene phenyl ether or polyoxyethylene naphthyl ether; and a polyoxyethylene alkylaryl ether, e.g., polyoxyethylene methylphenyl ether, polyoxyethylene octylphenyl ether or polyoxyethylene nonylphenyl ether.

The pH of the developer used in the plate-making method according to the invention is ordinarily from 11.0 to 12.7, preferably from 11.5 to 12.5, in view of the image formation and the damage of the exposed area in the development.

The electric conductivity of the developer used in the invention is preferably from 3 to 30 mS/cm. When it is less than the lower limit, dissolution of the photosensitive layer composition on the surface of support becomes difficult, resulting in formation of stain at printing in some cases. On the other hand, when it exceeds the upper limit, due to the high concentration of salt, a dissolution rate of the photosensitive layer becomes extremely low, resulting in remaining of the photosensitive layer in the unexposed area in some cases The electric conductivity is particularly preferably in the range from 5 to 20 mS/cm.

### [Exposure and Development Processing]

The photosensitive lithographic printing plate according to the invention is exposed imagewise using a conventionally known active ray, for example, a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser, a semiconductor laser (350 to 600 nm) or a solid or semiconductor laser emitting an infrared ray (700 to 1,200 nm), and then subjected to the development processing to form an image on the surface of the support.

Between the imagewise exposure and the development processing, a process of heating the photosensitive layer at a temperature of 50 to 140°C for 1 second to 5 minutes may be provided for the purpose of increasing a curing ratio of the photosensitive layer. The heating at the temperature in the above-described range serves to increase the curing ratio and prevents the occurrence of remaining layer due to dark polymerization in the unexposed area.

As described hereinbefore, the protective layer is provided on the photosensitive layer of the photosensitive lithographic printing plate according to the invention, and there are known a method of removing both the protective layer and the unexposed area of the photosensitive layer at the same time by using a developer and a method of first removing the protective layer with water or warm water, and then removing the unexposed area of the photosensitive layer by development. Into the water or warm water may be incorporated an antiseptic described in JP-A-10-10754 or an organic solvent described in JP-A-8-278636.

The development of the photosensitive lithographic printing plate according to the invention with the above-described developer is conducted in a conventional manner at a temperature from 0 to 60°C, preferably from about 15 to about 40°C, for example, by immersing the exposed photosensitive lithographic printing plate in the developer and rubbing with a brush.

Further, in the case of conducting the development processing using an automatic developing machine, the developer becomes fatigued in accordance with the processing amount, and hence the processing ability may be restored by using a replenisher or a fresh developer. The thus development-processed photosensitive lithographic printing plate is subjected to after-treatment with washing water, a rinse solution containing, for example, a surfactant, or a desensitizing solution containing, for example, gum arabic or a starch derivative as described, for example, in JP-A-54-8002, JP-A-55-115045 and JP-A-59-58431. In the after-treatment of the photosensitive lithographic printing plate according to the invention, these processings may be used in combination.

The printing plate thus-obtained by the above-described processing may be subjected to the after-exposure treatment described in JP-A-2000-89478 or a heating treatment, for example, baking, in order to improve printing durability.

The lithographic printing plate thus-obtained is mounted on an offset printing machine to print a large number of sheets.

### EXAMPLES

The present invention will be described in more detail with reference to the following examples, but the invention should not be construed as being limited thereto.

### EXAMPLES 1 TO 8 AND COMPARATIVE EXAMPLES 1 AND 2

### (Preparation of aluminum support)

A 0.3 mm-thick aluminum plate was etched by dipping in a 10% by weight aqueous sodium hydroxide solution at 60Â°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 coulomb/dm². Subsequently, the aluminum plate was dipped in a 1% by weight aqueous sodium hydroxide solution at 40Â°C for 5 seconds, dipped in a 30% by weight aqueous sulfuric acid solution at 60Â°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness was measured and found to be 0.3 Âµm (Ra value according to JIS B0601).

### (Formation of intermediate layer)

On the aluminum plate thus-treated was coated a coating solution for intermediate layer shown below using a bar coater, followed by drying at 80Â°C for 20 seconds. A coating amount of the intermediate layer after drying was 10 mg/m².

| | | |
|---|---|---|
| | Polymer compound A | 0.05 g |
| | Methanol | 27 g |
| | Ion-exchanged water | 3 g |

Polymer compound A:

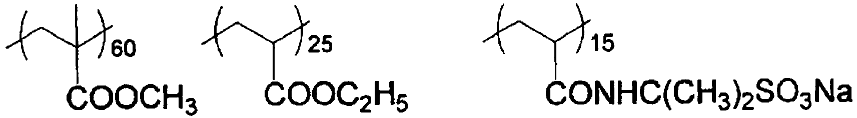

### (Formation of photosensitive layer)

Photopolymerizable composition P-1 of high sensitivity having the composition shown below was coated on the intermediate layer so as to have a dry coating amount of 1.4 g/m² and dried at 100Â°C for one minute to prepare a photosensitive layer. Photopolymerizable Composition P-1

| | | |
|---|---|---|
| | Ethylenically unsaturated bond-containing compound (A-1) | 1.0 part by weight |
| | Linear organic polymer (Polymer binder) (B-1) | 1.0 part by weight |
| | Sensitizing agent (C-1) | 0.15 parts by weight |
| | Photopolymerization initiator (D-1) | 0.12 parts by weight |
| | Co-sensitizer (E-1) | 0.5 parts by weight |
| | Îµ-Phthalocyanine dispersion (F-1) | 0.02 parts by weight |
| | Fluorine-containing nonionic surfactant (Megafac F780, produced by Dainippon Ink & Chemicals, Inc.) | 0.02 parts by weight |
| | Thermal polymerization inhibitor (Cupferron, produced by Wako Pure Chemical industries, Ltd.) | 0.02 parts by weight |
| | Methyl ethyl ketone | 26.0 parts by weight |
| | Propylene glycol monomethyl ether acetate | 26.3 parts by weight |

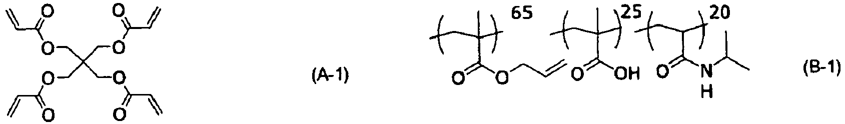

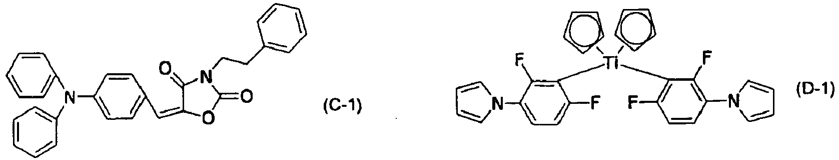

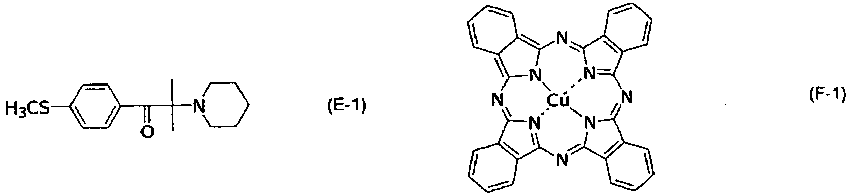

### (Formation of protective layer)

A composition for protective layer shown in Table 1 below was mixed, coated on the photosensitive layer and dried to from a protective layer, whereby a negative-working photosensitive lithographic printing plate [P1] was prepared. The drying conditions were 120°C for one minute.

**TABLE 1: COMPOSITION FOR PROTECTIVE LAYER**

| | | Protective Layer 1 | Protective Layer 2 | Protective Layer 3 | Protective Layer 4 | Protective Layer 5 | Protective Layer 6 | Protective Layer 7 | Protective Layer 8 | Comparative Protective Layer 1 | Comparative Protective Layer 2 |
|---|---|---|---|---|---|---|---|---|---|---|---|
| PVA | PVA 105 | 93 | 91 | 89 | 99 | 97 | 97 | 97 | 97 | 93.9 | 74 |
| Compound | (1) | 1 | 3 | 5 | 1 | 1 | 0 | 0 | 0 | 0.1 | 20 |
| | (2) | 0 | 0 | 0 | 0 | 0 | 1 | 0 | 0 | 0 | 0 |
| | (3) | 0 | 0 | 0 | 0 | 0 | 0 | 1 | 0 | 0 | 0 |
| | (4) | 0 | 0 | 0 | 0 | 0 | 0 | 0 | 1 | 0 | 0 |
| Addition Polymer | PVPK30 | 3.5 | 3.5 | 3.5 | 0 | 0 | 0 | 0 | 0 | 3.5 | 3.5 |
| | Luvitec VA64W | 2.5 | 2.5 | 2.5 | 0 | 0 | 0 | 0 | 0 | 2.5 | 2.5 |
| Surfactant | Emalex 710 | 0 | 0 | 0 | 0 | 2 | 2 | 2 | 2 | 0 | 0 |

| | | | | | | | | | | | |
|---|---|---|---|---|---|---|---|---|---|---|---|
| Compound (1): Sodium dibutylnaphthalenesulfonate, Compound (2): Sodium nonyldiphenylsulfate, Compound (3): Sodium dodecylbenzenesulfonate, Compound (4): Sodium triisopropylnaphthalenesulfate PVA 105: Polyvinyl alcohol (saponification degree: 98% by mole, polymerization degree: 500), produced by Kuraray Co., Ltd. PVPK30: Polyvinyl pyrrolidone, produced by Wako Pure Chemical industries, Ltd. Luvitec VA64W: Vinyl pyrrolidone-vinyl acetate copolymer, produced by ICP. Emalex 710: Nonionic surfactant, produced by Nihon-Emulsion Co., Ltd. | | | | | | | | | | | |

### [Evaluation]

### (Sensitivity)

The photosensitive lithographic printing plate obtained was subjected to drawing an FM screen image of 50% halftone dot (CoReScreening, produced by Fuji Photo Film Co., Ltd.) using Vx9600CTP (wavelength of light source: 405 nm, produced by Fuji Photo Film Co., Ltd.) while controlling an exposure amount on the surface of photosensitive lithographic printing plate to 0.07 mJ/cm². Then, it was developed using a processor (850PII, produced by Fuji Photo Film Co., Ltd.) fed with an alkali developer having the composition shown below at solution temperature of 28°C for development time of 20 seconds (standard condition). A halftone dot area of the image obtained was measured. The halftone dot area was determined by measuring a halftone dot area ratio (%) in a cyan mode using a reflection densitometer (Gretag D19C, produced by Gretag-Macbeth A. G.). As the value of halftone dot area ratio is larger, the sensitivity is higher.

### (Reproducibility of halftone dot)

The photosensitive lithographic printing plate obtained was subjected to drawing an FM screen image of 50% halftone dot (CoReScreening, produced by Fuji Photo Film Co., Ltd.) using Vx9600CTP (wavelength of light source: 405 nm, produced by Fuji Photo Film Co., Ltd.) while controlling an exposure amount on the surface of photosensitive lithographic printing plate to 0.07 mJ/cm². Then, it was developed using a processor (850PII, produced by Fuji Photo Film Co., Ltd.) fed with an alkali developer having the composition shown below at solution temperature of 28°C for development time of 20 seconds with increasing a brush pressure in the developing part of the processor in comparison with the standard condition (pressurized condition). A halftone dot area of the image obtained was measured in the same manner as above. A photosensitive lithographic printing plate exhibiting a small difference in the halftone dot area due to the variation of brush pressure is evaluated as a photosensitive lithographic printing plate having good reproducibility of halftone dot.

The results of evaluation are shown in Table 2 below.

**Composition of Alkali Developer**

| | | |
|---|---|---|
| | Potassium hydroxide | 0.15 g |
| | Polyoxyethylene naphthyl ether (n=13) | 5.0 g |
| | Chelest 400 (chelating agent) | 0.1 g |
| | Water | 94.75 g |

**TABLE 2**

| | Protective Layer | Sensitivity (50% halftone dot area) | Difference in Halftone Dot Area due to Variation of Brush Pressure (%) |
|---|---|---|---|
| Example 1 | 1 | 35 | 1 |
| Example 2 | 2 | 34.5 | 1.5 |
| Example 3 | 3 | 34 | 0.5 |
| Example 4 | 4 | 34.5 | 1.2 |
| Example 5 | 5 | 34.5 | 1.4 |
| Example 6 | 6 | 35 | 1 |
| Example 7 | 7 | 35 | 1.2 |
| Example 8 | 8 | 34 | 1.3 |
| Comparative Example 1 | Comparative Protective Layer 1 | 36 | 5 |
| Comparative Example 2 | Comparative Protective Layer 2 | Defective surface state | Defective surface state |

### EXAMPLES 9 AND 10 AND COMPARATIVE EXAMPLES 3 AND 4

In the same manner as in Example 1, photopolymerizable composition P-2 of high sensitivity having the composition shown below was coated on the intermediate layer so as to have a dry coating amount of 1.4 g/m² and dried at 100Â°C for one minute to prepare a photosensitive layer. Subsequently, a protective layer shown in Table 3 below was coated on the photosensitive layer in the same manner as in Example 1 to prepare photosensitive lithographic printing plates for Examples 9 and 10 and Comparative Examples 3 and 4 were prepared, respectively. The photosensitive lithographic printing plates were evaluated in the same manner as in Example 1. The results of evaluation are also shown in Table 3.

**Photopolymerizable Composition P-2**

| | | |
|---|---|---|
| | Ethylenically unsaturated bond-containing compound (A-2) | 0.46 parts by weight |
| | Linear organic polymer (Polymer binder) (B-1) | 0.51 parts by weight |
| | Sensitizing agent (C-2) | 0.03 parts by weight |
| | Bisimidazole | 0.12 parts by weight |
| | Chain Transfer Agent (E-2) | 0.3 parts by weight |
| | Îµ-Phthalocyanine dispersion (F-1) | 0.47 parts by weight |
| | Fluorine-containing nonionic surfactant (Megafac F780, produced by Dainippon Ink & Chemicals, Inc.) | 0.009 parts by weight |
| | Thermal polymerization inhibitor (Cupferron, produced by Wako Pure Chemical industries, Ltd.) | 0.003 parts by weight |
| | Methyl ethyl ketone | 7.4 parts by weight |
| | Propylene glycol monomethyl ether acetate | 7.4 parts by weight |

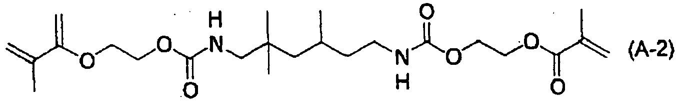

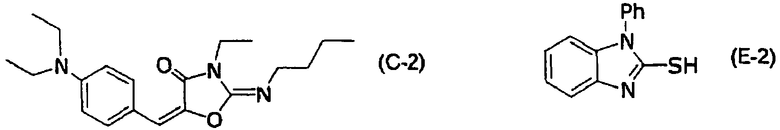

**TABLE 3**

| | Protective Layer | Sensitivity (50% halftone dot area) | Difference in Halftone Dot Area due to Variation of Brush Pressure (%) |
|---|---|---|---|
| Example 9 | 1 | 37 | 0.5 |
| Example 10 | 8 | 38 | 0.7 |
| Comparative Example 3 | Comparative Protective Laver 1 | 39 | 9 |
| Comparative Example 4 | Comparative Protective Layer 2 | Defective surface state | Defective surface state |

As is apparent from the results shown in Tables 2 and 3, the tone reproducibility can be improved without decrease in the sensitivity by adding the compound having a sulfonate or a sulfate ester salt to the protective layer.

Also, it can be seen that when the amount of the compound added is small, the difference in halftone dot area due to the variation of brush pressure is large, that is, the reproducibility of halftone dot is poor, and on the other hand, when the compound is excessively added, the defective surface state occur and the evaluation can not be conducted.

## Claims

1. A photosensitive lithographic printing plate comprising a hydrophilic support, a photosensitive layer and a protective layer in this order, wherein the photosensitive layer contains a compound having an ethylenically unsaturated double bond and a polymer binder, and the protective layer contains a sulphonate or a sulphate ester salt in an amount from 0.5 to 10% by weight, calculated in terms of the solid content of the protective layer, represented by the formula R-SO₃M or R-OSO₃M wherein R represents an optionally substituted aryl group and M represents a monovalent cation for forming a salt.

2. A photosensitive lithographic printing plate according to Claim 1, wherein the sulphonate or the sulphate ester salt is a surfactant.

3. A photosensitive lithographic printing plate according to Claim 1 or Claim 2, wherein the content of the sulphonate or the sulphate ester salt is from 0.7 to 8% by weight calculated in terms of a solid content of the protective layer.

4. A photosensitive lithographic printing plate according to Claim 3, wherein the content of the sulphonate or the sulphate ester salt is from 1 to 5% by weight calculated in terms of a solid content of the protective layer.

5. A photosensitive lithographic printing plate according to any preceding claim, wherein the substituted R represents an optionally substituted phenyl group or an optionally substituted naphthyl group.

6. A photosensitive lithographic printing plate according to any preceding claim, wherein the polymer binder in the photosensitive layer is a (meth)acrylic resin.

7. A photosensitive lithographic printing plate according to any preceding claim, wherein the protective layer contains 85% by weight or more of polyvinyl alcohol calculated in terms of the solid content of the protective layer.

## Patentansprüche

1. Lichtempfindliche Lithographiedruckplatte, umfassend einen hydrophilen Träger, eine lichtempfindliche Schicht und eine Schutzschicht in dieser Reihenfolge, wobei die lichtempfindliche Schicht eine Verbindung mit einer ethylenisch ungesättigten Doppelbindung und ein Polymerbindemittel enthält und die Schutzschicht ein Sulfonat oder ein Sulfatestersalz in einer Menge von 0,5 bis 10 Gew.%, berechnet in Bezug auf den Feststoffgehalt der Schutzschicht, dargestellt durch die Formel R-SO₃M oder R-OSO₃M, enthält, worin R eine gegebenenfalls substituierte Arylgruppe darstellt und M ein einwertiges Kation zur Bildung eines Salzes darstellt.

2. Lichtempfindliche Lithographiedruckplatte gemäß Anspruch 1, wobei das Sulfonat oder das Sulfatestersalz ein Tensid ist.

3. Lichtempfindliche Lithographiedruckplatte gemäß Anspruch 1 oder 2, wobei der Gehalt an dem Sulfonat oder dem Sulfatestersalz 0,7 bis 8 Gew.%, berechnet in Bezug auf einen Feststoffgehalt der Schutzschicht, beträgt.

4. Lichtempfindliche Lithographiedruckplatte gemäß Anspruch 3, wobei der Gehalt an dem Sulfonat oder dem Sulfatestersalz 1 bis 5 Gew.%, berechnet in Bezug auf einen Feststoffgehalt der Schutzschicht, beträgt.

5. Lichtempfindliche Lithographiedruckplatte gemäß irgendeinem der vorhergehenden Ansprüche, wobei das substituierte R eine gegebenenfalls substituierte Phenylgruppe oder eine gegebenenfalls substituierte Naphthylgruppe darstellt.

6. Lichtempfindliche Lithographiedruckplatte gemäß irgendeinem der vorhergehenden Ansprüche, wobei das Polymerbindemittel in der lichtempfindlichen Schicht ein (Meth)acrylharz ist.

7. Lichtempfindliche Lithographiedruckplatte gemäß irgendeinem der vorhergehenden Ansprüche, wobei die Schutzschicht 85 Gew.% oder mehr Polyvinylalkohol, berechnet in Bezug auf den Feststoffgehalt der Schutzschicht, enthält.

## Revendications

1. Plaque d'impression lithographique photosensible comprenant un support hydrophile, une couche photosensible et une couche protectrice dans cet ordre, dans laquelle la couche photosensible contient un composé ayant une double liaison éthyléniquement insaturée et un liant polymère et la couche protectrice contient un sulfonate ou un sel d'ester sulfate en quantité de 0,5 à 10 % en poids, calculée en fonction de la teneur en solides de la couche protectrice, représenté par la formule R-SO₃M ou R-OSO₃M, dans laquelle R représente un groupement aryle éventuellement substitué et M représente un cation monovalent pour former un sel.

2. Plaque d'impression lithographique photosensible selon la revendication 1, dans laquelle le sulfonate ou le sel d'ester sulfate est un agent tensioactif.

3. Plaque d'impression lithographique photosensible selon la revendication 1 ou la revendication 2, dans laquelle la teneur en sulfonate ou en sel d'ester sulfate est de 0,7 à 8 % en poids, calculée en fonction de la teneur en solides de la couche protectrice.

4. Plaque d'impression lithographique photosensible selon la revendication 3, dans laquelle la teneur en sulfonate ou en sel d'ester sulfate est de 1 à 5 % en poids, calculée en fonction de la teneur en solides de la couche protectrice.

5. Plaque d'impression lithographique photosensible selon l'une quelconque des revendications précédentes, dans laquelle le groupement R substitué représente un groupement phényle éventuellement substitué ou un groupement naphtyle éventuellement substitué.

6. Plaque d'impression lithographique photosensible selon l'une quelconque des revendications précédentes, dans laquelle le liant polymère dans la couche photosensible est une résine (méth)acrylique.

7. Plaque d'impression lithographique photosensible selon l'une quelconque des revendications précédentes, dans laquelle la couche protectrice contient au moins 85 % en poids ou plus d'alcool polyvinylique calculés en fonction de la teneur en solides de la couche protectrice.
